# EUROPEAN PATENT APPLICATION

(11) **EP 4 358 676 A1**
(43) Date of publication of application: **24.04.2024**
(21) Application number: 23203873.7
(22) Date of filing: 16.10.2023
(51) Int. Cl.: H10K 50/17

(54) **LIGHT-EMITTING DEVICE AND ELECTRONIC APPARATUS INCLUDING THE SAME**

(30) Priority: 18.10.2022 KR 20220134443
(71) Applicant: Samsung Display Co., Ltd., Yongin-si, Gyeonggi-do 17113 (KR)
(72) Inventor: Sung, Hyangki, 17113 Yongin-si (KR); Kim, Dalho, 17113 Yongin-si (KR); Han, Jongseok, 17113 Yongin-si (KR); Park, Eunji, 17113 Yongin-si (KR); Jeong, Heeseong, 17113 Yongin-si (KR)
(74) Representative: Taor, Simon Edward William

(57) **Abstract**

Provided is a light-emitting device including a first electrode, a second electrode facing the first electrode, an emission layer between the first electrode and the second electrode, and an electron transport region between the emission layer and the second electrode, wherein the electron transport region includes an electron injection layer including a first material and a second material, the first material and the second material each independently include an alkali metal, an alkaline earth metal, a transition metal, a post-transition metal, a lanthanide metal, or a combination thereof, the second material does not include Mg, the first material and the second material are different from each other, and a surface energy of the second material is greater than a surface energy of the first material.

## Description

### CROSS-REFERENCE TO RELATED APPLICATION

This application claims priority to and the benefit of Korean Patent Application No. 10-2022-0134443, filed on October 18, 2022, in the Korean Intellectual Property Office.

### BACKGROUND

### 1. Field

One or more embodiments of the present disclosure relate to a light-emitting device and an electronic apparatus including the same.

### 2. Description of the Related Art

A light-emitting device may include a first electrode, a hole transport region, an emission layer, an electron transport region, and a second electrode. Holes provided from the first electrode move toward the emission layer through the hole transport region. Electrons provided from the second electrode move toward the emission layer through an electron injection layer of the electron transport region. Carriers such as holes and electrons may recombine in the emission layer. Excitons may be produced by the recombination of the carriers. These excitons transition from an excited state to a ground state to generate light.

For high luminescence efficiency, the light-emitting device may be designed to have a microcavity structure in which constructive interference between multi-reflected light occurs in the first electrode and the second electrode. If the second electrode is not substantially flat, the resonance of the light-emitting device may be weakened, thereby decreasing the luminescence efficiency and relatively increasing the sheet resistance of the second electrode. Therefore, in order to improve the luminescence efficiency of the light-emitting device by increasing the resonance of light, and to reduce the sheet resistance of the second electrode to improve the driving voltage and power consumption of the light-emitting device, it may be necessary or desirable to form the second electrode to be substantially flat and smooth.

### SUMMARY

One or more embodiments of the present disclosure provide a light-emitting device having improved luminescence efficiency, driving voltage, and/or power consumption.

Additional aspects of embodiments will be set forth in part in the description which follows and, in part, will be apparent from the description, or may be learned by practice of the presented embodiments of the disclosure.

According to one or more embodiments, a light-emitting device includes a first electrode, a second electrode facing the first electrode, an emission layer between the first electrode and the second electrode, and an electron transport region between the emission layer and the second electrode, wherein the electron transport region may include an electron injection layer including a first material and a second material, the first material and the second material may each independently include an alkali metal, an alkaline earth metal, a transition metal, a post-transition metal, a lanthanide metal, or a combination thereof, the second material may not include Mg, the first material and the second material may be different from each other, and a surface energy of the second material may be greater than a surface energy of the first material.

In some embodiments, the electron injection layer is a single layer.

In some embodiments, the first material is i) an alkali metal, an alkaline earth metal, and/or a lanthanide metal, ii) a halide of an alkali metal, a halide of an alkaline earth metal, and/or a halide of a lanthanide metal, or iii) a combination thereof.

In some embodiments, the first material is LiF or Yb.

In some embodiments, the second material comprises a transition metal or a post-transition metal.

In some embodiments, the second material is Ag, Au, Al, or a combination thereof.

In some embodiments, the surface energy of the second material is about 0.8 J/m² or more.

In some embodiments, a volume of the first material included in the electron injection layer is greater than a volume of the second material included in the electron injection layer.

In some embodiments, a volume ratio of the first material to the second material in the electron injection layer is about 0.2:1 to about 4:1.

In some embodiments, the electron injection layer further comprises a third material comprising an alkali metal, an alkaline earth metal, a transition metal, a post-transition metal, a lanthanide metal, or a combination thereof, and the third material is different from the first material and the second material.

In some embodiments, the third material comprises an alkaline earth metal.

In some embodiments, the third material is Mg or Ca.

In some embodiments, a radius of an atom of a metal included in the third material is less than a radius of an atom of a metal included in the first material.

In some embodiments, a volume of the second material included in the electron injection layer is substantially equal to a volume of the third material included in the electron injection layer.

In some embodiments, a thickness of the electron injection layer is about 0.5 nm to about 2 nm.

In some embodiments, the electron injection layer is formed by co-depositing the first material and the second material.

In some embodiments, the electron injection layer is in direct contact with the second electrode.

In some embodiments, the light-emitting device further comprises: a hole transport region between the first electrode and the emission layer, wherein: the hole transport region comprises a hole injection layer, a hole transport layer, an emission auxiliary layer, an electron blocking layer, or a combination thereof.

According to one or more embodiments, an electronic apparatus includes the light-emitting device.

In some embodiments, the electronic apparatus further comprises: a thin-film transistor electrically connected to the first electrode; and a color filter, a color conversion layer, a touch screen layer, a polarizing layer, or a combination thereof.

According to one or more embodiments, the electronic apparatus further includes a thin-film transistor electrically connected to the first electrode, and a color filter, a color conversion layer, a touch screen layer, a polarizing layer, or a combination thereof.

According to an aspect, there is provided a light-emitting device as set out in claim 1. Additional features are set out in claims 2 to 18. According to an aspect, there is provided an electronic apparatus as set out in claim 19. Additional features are set out in claim 20.

### BRIEF DESCRIPTION OF THE DRAWINGS

The above and other aspects and features of certain embodiments of the disclosure will be more apparent from the following description taken in conjunction with the accompanying drawings, in which:
FIG. 1 is a schematic cross-sectional view of a light-emitting device according to one or more embodiments;
FIG. 2 is a schematic cross-sectional view of an electronic apparatus according to one or more embodiments;
FIG. 3 is a schematic cross-sectional view of an electronic apparatus according to another embodiment;
FIG. 4 is a perspective view schematically illustrating an electronic apparatus including a light-emitting device according to one or more embodiments;
FIG. 5 is a schematic perspective view illustrating the exterior of a vehicle as an electronic apparatus including a light-emitting device according to one or more embodiments;
FIGS. 6A to 6C are each a schematic interior view illustrating the interior of the vehicle of FIG. 5;
FIGS. 7A to 7C are graphs illustrating luminescence efficiencies according to color coordinates (CIEx or CIEy) in the light-emitting devices of Example 1 and Comparative Examples 1 to 3; and
FIG. 8 is a graph illustrating sheet resistance according to thickness of a second electrode in the light-emitting devices of Examples 1 to 3 and Comparative Examples 4 to 6.

### DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of embodiments of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

According to one or more embodiments, a light-emitting device may include: a first electrode; a second electrode facing the first electrode; an emission layer between the first electrode and the second electrode; and an electron transport region between the emission layer and the second electrode, wherein the electron transport region may include an electron injection layer including a first material and a second material, the first material and the second material may each independently include an alkali metal, an alkaline earth metal, a transition metal, a post-transition metal, a lanthanide metal, or a combination thereof, the second material may not include Mg, the first material and the second material may be different from each other, and a surface energy of the second material may be greater than a surface energy of the first material. For example, a surface energy of a monolith of the first material (e.g., a sample of only or substantially only the first material) is less than a surface energy of a monolith of the second material (e.g., a sample of only or substantially only the second material). A surface energy of the electron injection layer may be determined by a composition of the first material and the second material, and the surface energy of the electron injection layer may be different from the surface energy of the first material and the surface energy of the second material.

In one or more embodiments, the electron injection layer may include a mixture including a first material and a second material. For example, the electron injection layer may include a single or sole layer including a mixture in which the first material and the second material are mixed together.

In one or more embodiments, the electron injection layer may be a multi-layer. For example, the electron injection layer may have a multi-layer structure including a plurality of layers in which a first layer including the first material and a second layer including the second material are included. In one or more embodiments, the first material and the second material may be included in a first layer of the multi-layer of the electron injection layer as a mixture, and a remaining layer or remaining layers of the multi-layer may or may not include the first material and/or the second material. When the electron injection layer has a multi-layer structure including a plurality of layers, at least the layer closest to the second electrode includes the first material, the second material, and/or the third material. In one or more embodiments, layer closest to the second electrode includes the second material.

In one or more embodiments, the first material may include i) an alkali metal, an alkaline earth metal, and/or a lanthanide metal, ii) a halide of an alkali metal, a halide of an alkaline earth metal, and/or a halide of a lanthanide metal, or iii) a combination thereof. The first material may include Li, Na, K, Rb, Cs, Mg, Ca, Sr, Ba, La, Ce, Sm, Gd, Tb, Yb or a combination thereof. The first material may be LiF, and/or Yb.

In one or more embodiments, the second material may include a transition metal and/or a post-transition metal. The second material may be Ag, Au, Al, or a combination thereof.

In one or more embodiments, the surface energy of the second material may be about 0.8 J/m² or more. For example, the surface energy of the second material may be about 0.8 J/m² to about 3.5 J/m², or about 1.0 J/m² to about 3.5 J/m². When the surface energy of the second material falls within the foregoing ranges and is greater than the surface energy of the first material, and/or when the surface energy of the second material is the same as or greater than a surface energy of the second electrode, the second electrode may be formed to have a smooth surface.

In one or more embodiments, the second electrode may include Ag, Mg, or a combination thereof.

In one or more embodiments, the surface energy of the second material may be substantially the same as or greater than a surface energy of the second electrode. For example, the second electrode may have a smooth surface when the surface energy of the second material is the same or substantially the same as the surface energy of the second electrode. The greater the surface energy of the second material than the surface energy of the second electrode, a second electrode having a smooth surface may be formed. For example, the greater the surface energy of the second material than the surface energy of the second electrode, the smoother the second electrode may be.

In one or more embodiments, the volume of the first material included in the electron injection layer may be greater than the volume of the second material included in the electron injection layer. For example, in the electron injection layer, the volume content of the first material may be greater than the volume content of the second material.

In one or more embodiments, the volume ratio of the first material to the second material in the electron injection layer may be about 0.2:1 to about 4:1. For example, the volume ratio of the first material to the second material of the electron injection layer may be about 1.5:1 to about 3:1, for example, about 2:1.

In one or more embodiments, a radius of an atom of the metal included in the second material may be less than a radius of an atom of the metal included in the first material. The metal included in the second material may fill a space between the metal (or metal atoms) included in the first material, and thus, the electron injection layer including the first material and the second material may be substantially flat. For example, by suitably selecting the radii of the respective metal atoms of the first material and the second material, the electron injection layer can be made to have a flat surface, thereby providing a smoother and/or flatter second electrode, which is in physical contact with the electron injection layer (e.g., is in physical contact with the first material and/or the second material).

In one or more embodiments, the electron injection layer may further include a third material including an alkali metal, alkaline earth metal, a transition metal, a post-transition metal, a lanthanide metal, or a combination thereof, and the third material may be different from the first material and the second material.

In one or more embodiments, the electron injection layer may include a mixture including the first material to the third material. For example, the electron injection layer may include a single or sole layer including a mixture in which the first material, the second material, and the third material are mixed together.

In one or more embodiments, the electron injection layer may have a multi-layer. For example, the electron injection layer may have a multi-layer structure including a plurality of layers in which a first layer including the first material, a second layer including the second material, and/or a third layer including the third material are included. In one or more embodiments, the first material, the second material, and the third material may be included in a first layer of the multi-layer of the electron injection layer as a mixture, and a remaining layer or remaining layers of the multi-layer may or may not include the first material, the second material, and/or the third material. When the electron injection layer has a multi-layer structure including a plurality of layers, at least the layer closest to the second electrode includes the first material and/or the second material. In one or more embodiments, layer closest to the second electrode includes the second material.

In one or more embodiments, the third dopant may include an alkaline earth metal. For example, the third material may be Mg and/or Ca.

In one or more embodiments, a radius of an atom of the metal included in the third material may be less than the radius of the atom of the metal included in the first material or the radius of the atom of the metal included in the second material. Because the metal included in the third material fills spaces in or between the metal (or metal atoms) included in the first material or spaces in or between the metal (or metal atoms) including the second material (e.g., spaces between metal atoms of the first material, between metal atoms of the second metal, and/or between at least one metal atom of the first material and at least one metal atom of the second material), the electron injection layer including the first material, the second material, and the third material may substantially be flat. For example, by suitably selecting the radii of the respective metal atoms of the first material, the second material, and/or the third material, the electron injection layer can be made to have a flat surface, thereby providing a smoother and/or flatter second electrode, which is in physical contact with the electron injection layer (e.g., is in physical contact with the first material, the second material, and/or the third material).

In one or more embodiments, the surface energy of the third material may be greater than or equal to the surface energy of the first material. For example, a surface energy of a monolith of the first material (e.g., a sample of only or substantially only the first material) is less than a surface energy of a monolith of the third material (e.g., a sample of only or substantially only the third material).

In one or more embodiments, the volume of the second material included in the electron injection layer may be equal to the volume of the third material included in the electron injection layer. For example, in the electron injection layer, the volume content of the second material may be equal to the volume content of the third material.

In one or more embodiments, the volume ratio of the second material to the third material in the electron injection layer may be about 1.2:1 to about 1:1.2. In one or more embodiments, the volume ratio of the second material to the third material in the electron injection layer may be about 1:1.

In one or more embodiments, the thickness of the electron injection layer may be in a range of about 5 Å to about 20 Å. For example, the thickness of the electron injection layer may be in a range of about 7 Å to about 18 Å. For example, the thickness of the electron injection layer may be about 8 Å to about 15 Å.

In one or more embodiments, the electron injection layer may be formed by co-deposition of the first material and the second material. For example, the first material and the second material may be mixed together with each other.

In one or more embodiments, the electron injection layer may be formed by co-deposition of the first material, the second material, and the third material. For example, the first material, the second material, and the third material may be mixed together with each other.

In one or more embodiments, the electron injection layer may be in direct contact (e.g., physical contact) with the second electrode. For example, an interface may be formed between the electron injection layer and the second electrode.

In one or more embodiments, the electron transport region may further include a buffer layer, a hole blocking layer, an electron control layer, an electron transport layer, or a combination thereof.

In one or more embodiments, the light-emitting device may further include a hole transport region between the first electrode and the emission layer, and the hole transport region may include a hole injection layer, a hole transport layer, an emission auxiliary layer, an electron blocking layer, or a combination thereof.

In one or more embodiments, an electronic apparatus may include the light-emitting device.

In one or more embodiments, the electronic apparatus may further include a thin-film transistor (TFT) electrically connected to the first electrode; and a color filter, a color conversion layer, a touch screen layer, a polarizing layer, or a combination thereof.

Referring to Vitos, Levente, et al., "The surface energy of metals," Surface science 411,1-2 (1998): 186-202, Gilman, John J., "Direct measurements of the surface energies of crystals," Journal of applied physics 31,12 (1960): 2208-2218, and Clementi, Enrico, D. L. Raimondi, and William P. Reinhardt, "Atomic screening constants from SCF functions. II. Atoms with 37 to 86 electrons," The Journal of chemical physics 47,4 (1967): 1300-1307, respective surface energies and radii of atoms of materials that may be used in the electron injection layer are shown in Table 1. Because LiF in Table 1 has an ion combination length and not a radius of the atom of the metal, LiF does not indicate the radius of the atom of the metal. Referring to Pelatt, Brian D., John F. Wager, and Douglas A. Keszler, "Elucidation of bonding trends from variability in Atomic Solid State Energies," Journal of Solid State Chemistry 274 (2019): 337-351, the ion combination length of LiF may be about 2.09 Å.

**Table 1**

| Material | Yb | LiF | Ag | Al | Au | Mg | Ca |
|---|---|---|---|---|---|---|---|
| Surface energy (J/m²) | 0.5 | 0.34 | 1.25 | 1.15 | 1.5 | 0.785 | 0.5 |
| Radius of atom of metal (Å) | 2.22 | | 1.65 | 1.18 | 1.74 | 1.45 | 1.94 |

The electronic injection layer of the light-emitting device according to one or more embodiments may include i) the first material and ii) the second material having a relatively greater surface energy or a surface energy that is substantially similar to the surface energy of the second electrode (for example, a cathode). As a result, because the electron injection layer is formed to be substantially flat, the second electrode on the electronic injection layer may be formed to be substantially flat, and/or an interaction between the electron injection layer and the second electrode may increase, and thus, the second electrode may be formed as a substantially smooth thin film.

Because the second electrode is substantially flat and smooth, a resonance of the light-emitting device may be increased (e.g., a participation of the second electrode may be improved or increased) and the luminescence efficiency of the light-emitting device may be improved.

In addition, because the second electrode is formed as a substantially smooth thin film on the electronic injection layer rather than being aggregated to each other to form pores, the sheet resistance of the second electrode may be reduced, thereby improving the driving voltage and power consumption of the light-emitting device.

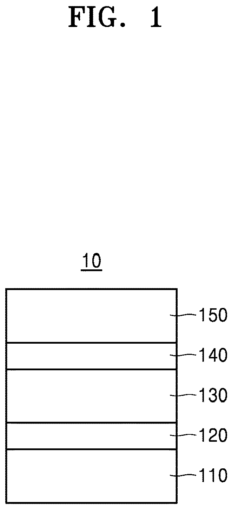

### Description of FIG. 1

FIG. 1 is a schematic cross-sectional view of a light-emitting device 10 according to one or more embodiments. The light-emitting device 10 may include a first electrode 110, a hole transport region 120, an emission layer 130, an electron transport region 140, and a second electrode 150.

Hereinafter, the structure of the light-emitting device 10 according to one or more embodiments and a method of manufacturing the light-emitting device 10 will be described with reference to FIG. 1.

### First electrode 110

In FIG. 1, a substrate may be additionally under the first electrode 110 or on the second electrode 150. As the substrate, a glass substrate and/or a plastic substrate may be used. The substrate may be a flexible substrate. For example, the substrate may include plastics having excellent heat resistance and durability, such as polyimide, polyethylene terephthalate (PET), polycarbonate, polyethylene naphthalate, polyarylate (PAR), polyetherimide, or a combination thereof.

The first electrode 110 may be formed by depositing and/or sputtering a material used for the first electrode on the substrate. When the first electrode 110 is an anode, a material for forming the first electrode 110 may be a high work function material to facilitate injection of holes.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide (SnO₂), zinc oxide (ZnO), or a combination thereof. When the first electrode 110 is a semi-transmissive electrode or a reflective electrode, magnesium (Mg), silver (Ag), aluminum (Al), aluminum-lithium (Al-Li), calcium (Ca), magnesium-indium (Mg-In), magnesium-silver (Mg-Ag), or a combination thereof may be used as a material for forming a first electrode.

The first electrode 110 may have a single-layered structure consisting of a single layer, or a multi-layered structure including a plurality of layers. For example, the first electrode 110 may have a three-layered structure of ITO/Ag/ITO.

### Hole transport region 120

The hole transport region may have: i) a single-layered structure consisting of a single layer consisting of a single material, ii) a single-layered structure consisting of a single layer consisting of a plurality of different materials, or iii) a multi-layered structure including a plurality of layers including different materials.

The hole transport region may include a hole injection layer, a hole transport layer, an emission auxiliary layer, an electron blocking layer, or a combination thereof.

For example, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, the layers of each structure being stacked sequentially from the first electrode 110.

The hole transport region may include a compound represented by Formula 201, a compound represented by Formula 202, or a combination thereof: 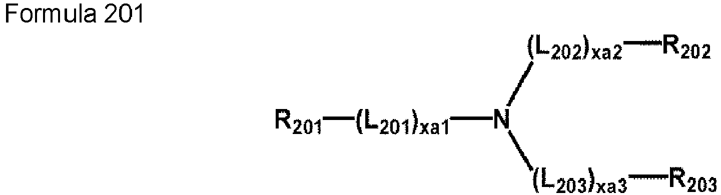 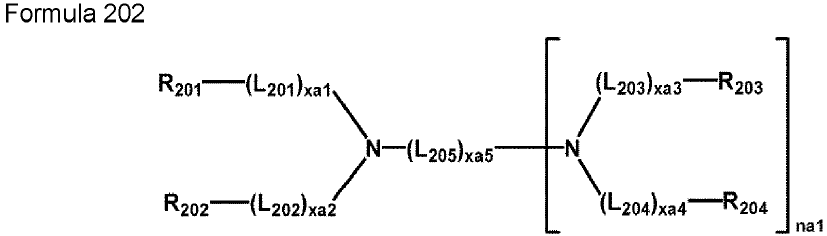
wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ, or a C₁-C₆₀ heterocyclic group unsubstituted or substituted with at least one R₁₀ₐ,
R₂₀₁ and R₂₀₂ may optionally be linked to each other via a single bond, a C₁-Cs alkylene group unsubstituted or substituted with at least one R₁₀ₐ, or a C₂-C₆ alkenylene group unsubstituted or substituted with at least one R₁₀ₐ, to form a C₆-C₆₀ polycyclic group (for example, a carbazole group or the like) unsubstituted or substituted with at least one R₁₀ₐ (for example, Compound HT16),
R₂₀₃ and R₂₀₄ may optionally be linked to each other via a single bond, a C₁-Cs alkylene group unsubstituted or substituted with at least one R₁₀ₐ, or a C₂-C₆ alkenylene group unsubstituted or substituted with at least one R₁₀ₐ, to form a C₆-C₆₀ polycyclic group unsubstituted or substituted with at least one R₁₀ₐ, and
na1 may be an integer from 1 to 4.

For example, each of Formulae 201 and 202 may include at least one selected from groups represented by Formulae CY201 to CY217:

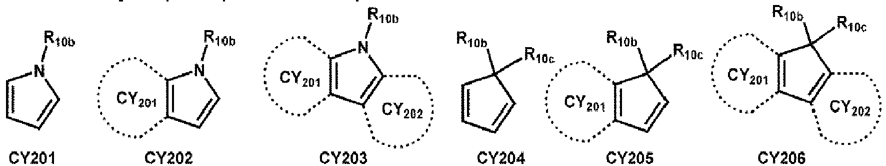

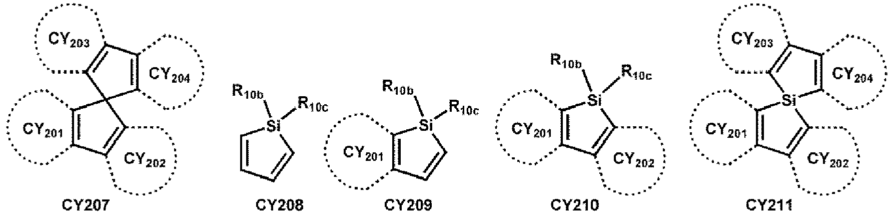

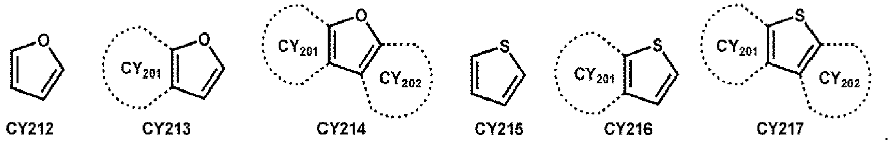

In Formulae CY201 to CY217, R_{10b} and R_{10c} may each be as described for R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ as described above.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one selected from groups represented by Formulae CY201 to CY203.

In one or more embodiments, Formula 201 may include at least one selected from the groups represented by Formulae CY201 to CY203 and at least one selected from the groups represented by Formulae CY204 to CY217.

In one or more embodiments, in Formula 201, xa1 may be 1, R₂₀₁ may be a group represented by one selected from Formulae CY201 to CY203, xa2 may be 0, and R₂₀₂ may be a group represented by one selected from Formulae CY204 to CY207.

In one or more embodiments, each of Formulae 201 and 202 may not include a group represented by one selected from Formulae CY201 to CY203.

In one or more embodiments, each of Formulae 201 and 202 may not include a group represented by one selected from Formulae CY201 to CY203, and may include at least one selected from the groups represented by Formulae CY204 to CY217.

In one or more embodiments, each of Formulae 201 and 202 may not include a group represented by one selected from Formulae CY201 to CY217.

In one or more embodiments, the hole transport region may include one selected from Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or a combination thereof:

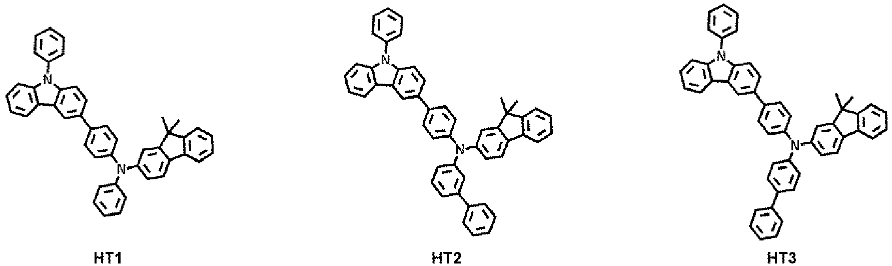

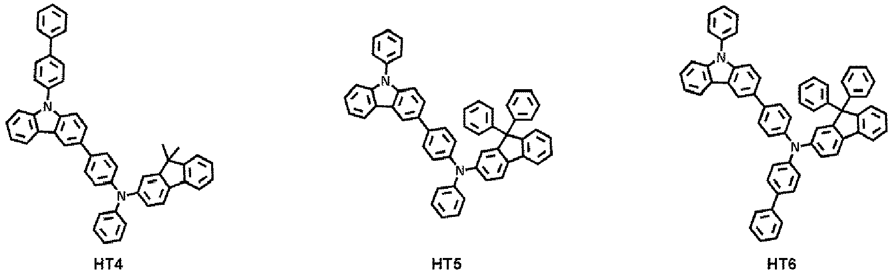

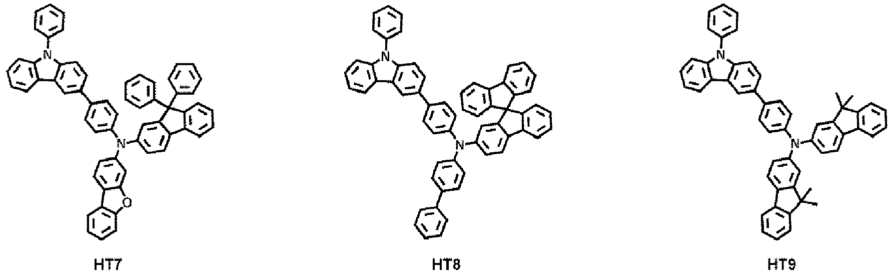

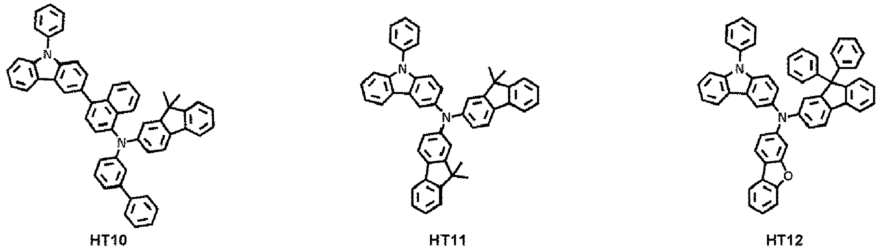

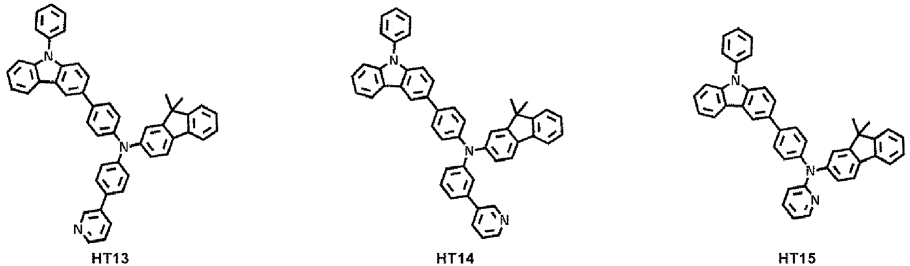

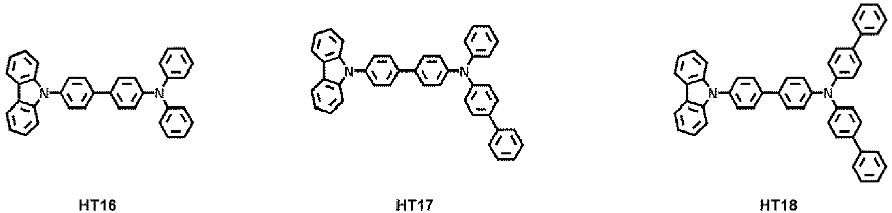

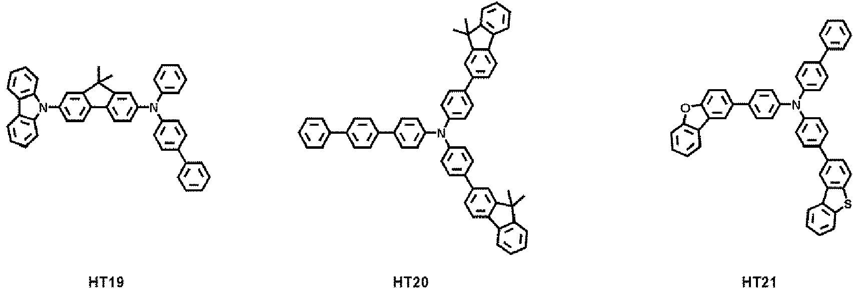

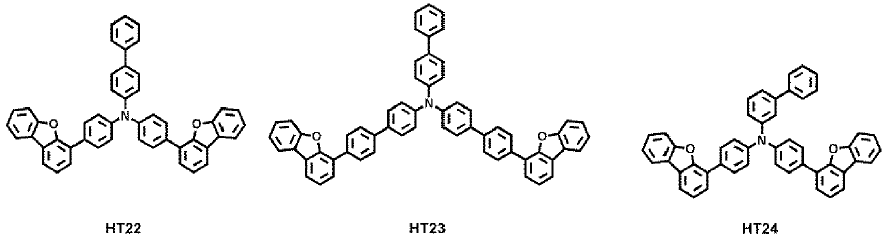

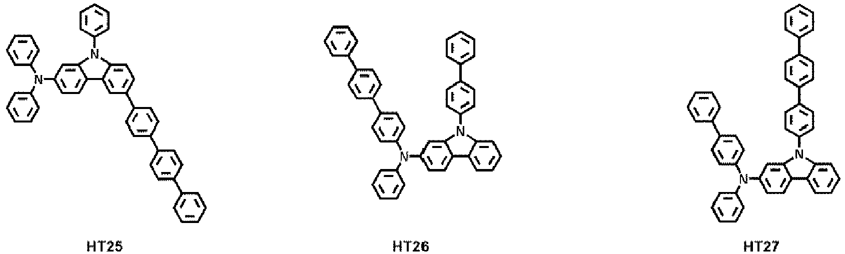

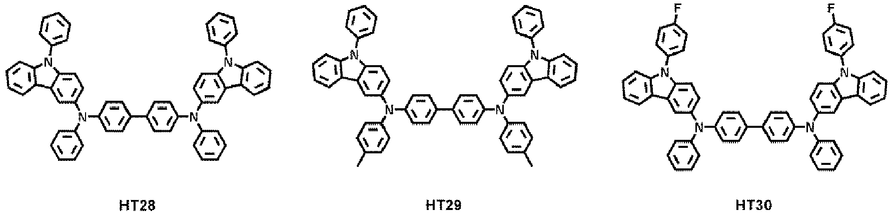

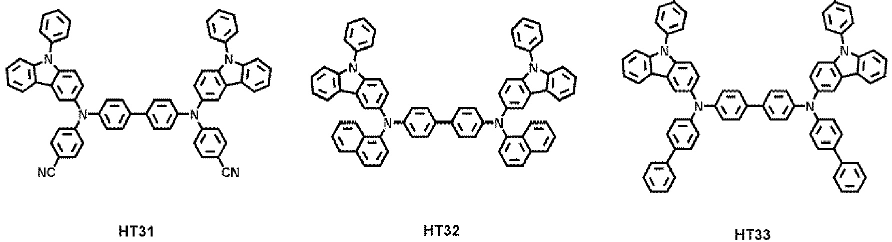

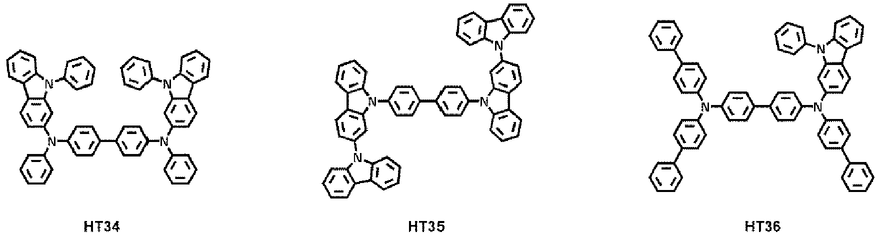

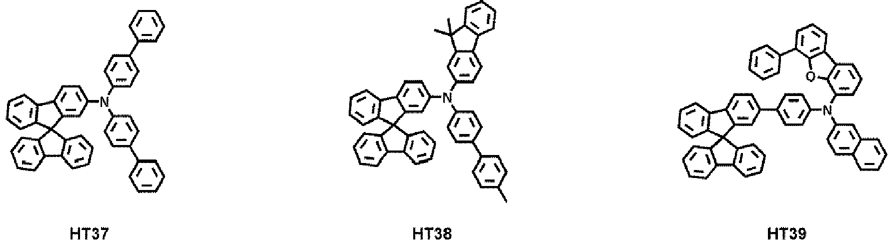

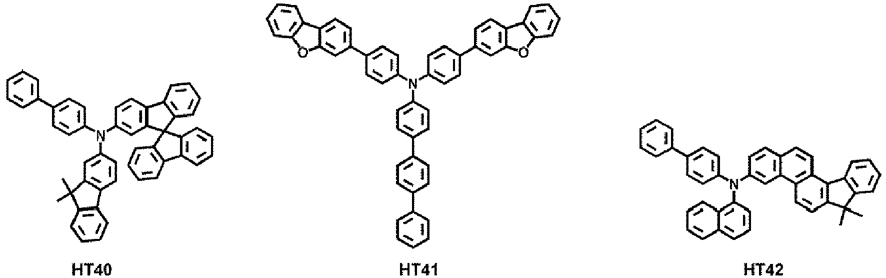

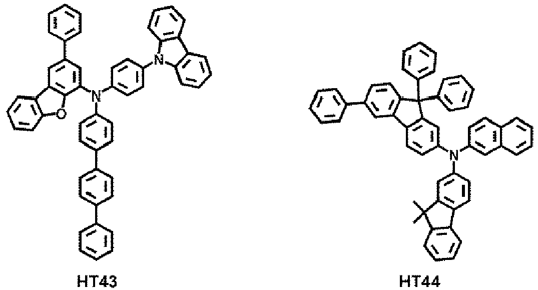

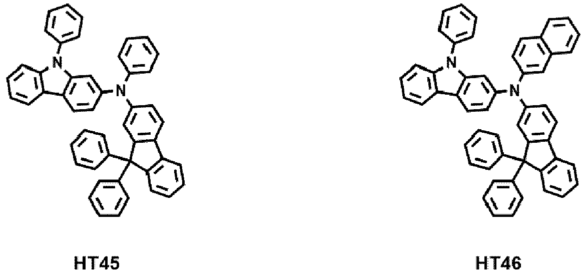

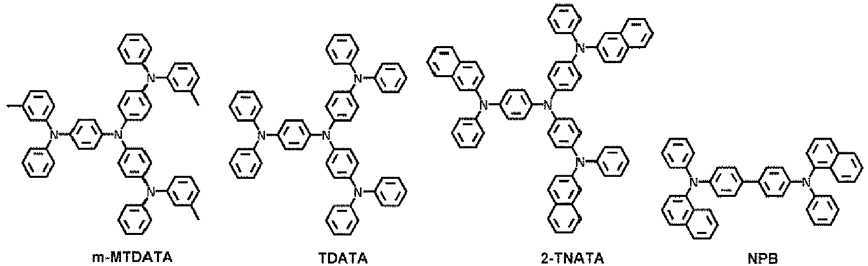

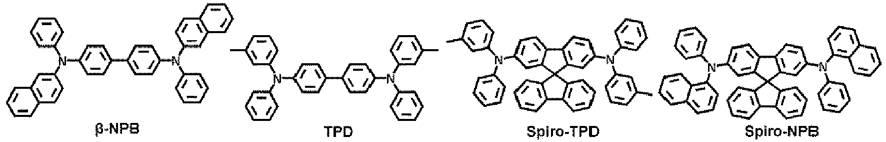

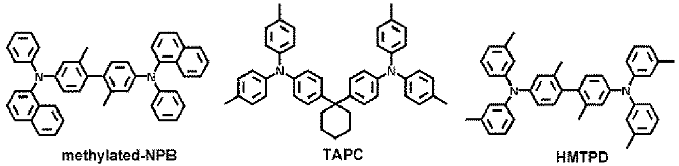

A thickness of the hole transport region may be in a range of about 50 Å to about 10,000 Å, for example, about 100 Å to about 4,000 Å. When the hole transport region includes a hole injection layer, a hole transport layer, or a combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, suitable or satisfactory hole transporting characteristics may be obtained without a substantial increase in driving voltage.

The emission auxiliary layer may compensate for an optical resonance distance according to a wavelength of light emitted from the emission layer, and thus, light-emission efficiency of the light-emitting device may be improved. The electron blocking layer may be a layer that prevents or reduces electron leakage from the emission layer to the hole transport region. Materials that may be included in the hole transport region may be included in the emission auxiliary layer and the electron blocking layer.

### p-dopant

The hole transport region may further include, in addition to these materials, a charge-generation material for the improvement of conductive properties (e.g., electrically conductive properties). The charge-generation material may be uniformly or non-uniformly dispersed in the hole transport region (for example, in the form of a single layer consisting of a charge-generation material).

The charge-generation material may be, for example, a p-dopant.

For example, the lowest unoccupied molecular orbital (LUMO) energy level of the p-dopant may be -3.5 eV or less.

In one or more embodiments, the p-dopant may include a quinone derivative, a cyano group-containing compound, a compound including element EL1 and element EL2, or a combination thereof.

Examples of the quinone derivative include TCNQ, F4-TCNQ, etc.

Examples of the cyano group-containing compound include HAT-CN and a compound represented by Formula 221 below:

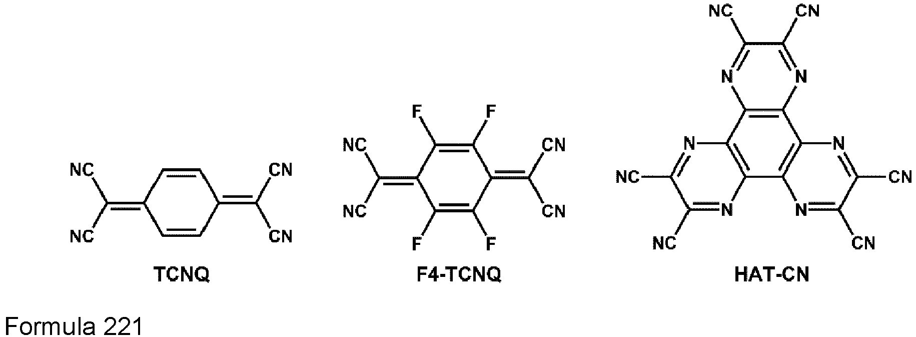

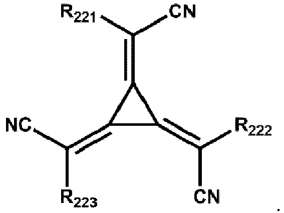

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one selected from R₂₂₁ to R₂₂₃ may each independently be a C₃-C₆₀ carbocyclic group or a C₁-C₆₀ heterocyclic group, each substituted with a cyano group; -F; -Cl; -Br; -I; a C₁-C₂₀ alkyl group substituted with a cyano group, -F, -Cl, -Br, -I, or a combination thereof; or a combination thereof.

In the compound including element EL1 and element EL2, element EL1 may be metal, metalloid, or a combination thereof, and element EL2 may be non-metal, metalloid, or a combination thereof.

Examples of the metal include an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, scandium (Sc), yttrium (Y), titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, aluminum (Al), zinc (Zn), gallium (Ga), indium (In), tin (Sn), etc.); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of the metalloid include silicon (Si), antimony (Sb), and tellurium (Te).

Examples of the non-metal include oxygen (O) and halogen (for example, F, Cl, Br, I, etc.).

Examples of the compound including element EL1 and element EL2 include metal oxide, metal halide (for example, metal fluoride, metal chloride, metal bromide, and/or metal iodide), metalloid halide (for example, metalloid fluoride, metalloid chloride, metalloid bromide, and/or metalloid iodide), metal telluride, or a combination thereof.

Examples of the metal oxide include a tungsten oxide (for example, WO, W₂O₃, WO₂, WO₃, W₂O₅, etc.), a vanadium oxide (for example, VO, V₂O₃, VO₂, V₂O₅, etc.), a molybdenum oxide (for example, MoO, Mo₂O₃, MoO₂, MoOs, Mo₂O₆, etc.), and a rhenium oxide (for example, ReOs, etc.).

Examples of the metal halide include alkali metal halide, alkaline earth metal halide, transition metal halide, post-transition metal halide, and lanthanide metal halide.

Examples of the alkali metal halogen include LiF, NaF, KF, RbF, CsF, LiCl, NaCl, KCl, RbCl, CsCl, LiBr, NaBr, KBr, RbBr, CsBr, Lil, Nal, KI, Rbl, Csl, etc.

Examples of the alkaline earth metal halide include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, etc

Examples of the transition metal halide include titanium halide (for example, TiF₄, TiCl₄, TiBr₄, TiI₄, etc.), zirconium halide (for example, ZrF₄, ZrCl₄, ZrBr₄, ZrI₄, etc.), hafnium halide (for example, HfF₄, HfCl₄, HfBr₄, HfI₄, etc.), vanadium halide (for example, VF₃, VCl₃, VBr₃, VI₃, etc.), niobium halide (for example, NbF₃, NbCl₃, NbBr₃, NbI₃, etc.), tantalum halide (for example, TaF₃, TaCl₃, TaBr₃, TaI₃, etc.), chromium halide (for example, CrF₃, CrCl₃, CrBr₃, CrI₃, etc.), molybdenum halide (for example, MoF₃, MoCl₃, MoBr₃, MoI₃, etc.), tungsten halide (for example, WF₃, WCl₃, WBr₃, WI₃, etc.), manganese halide (for example, MnF₂, MnCl₂, MnBr₂, MnI₂, etc.), technetium halide (for example, TcF₂, TcCl₂, TcBr₂, TcI₂, etc.), rhenium halide (for example, ReF₂, ReCl₂, ReBr₂, ReI₂, etc.), iron halide (for example, FeF₂, FeCl₂, FeBr₂, FeI₂, etc.), ruthenium halide (for example, RuF₂, RuCl₂, RuBr₂, RuI₂, etc.), osmium halide (for example, OsF₂, OsCl₂, OsBr₂, OsI₂, etc.), cobalt halide (for example, CoF₂, CoCl₂, CoBr₂, CoI₂, etc.), rhodium halide (for example, RhF₂, RhCl₂, RhBr₂, RhI₂, etc.), iridium halide (for example, IrF₂, IrCl₂, IrBr₂, IrI₂, etc.), nickel halide (for example, NiF₂, NiCl₂, NiBr₂, NiI₂, etc.), palladium halide (for example, PdF₂, PdCl₂, PdBr₂, PdI₂, etc.), platinum halide (for example, PtF₂, PtCl₂, PtBr₂, PtI₂, etc.), copper halide (for example, CuF, CuCl, CuBr, Cul, etc.), silver halide (for example, AgF, AgCl, AgBr, Agl, etc.), gold halide (for example, AuF, AuCl, AuBr, Aul, etc.), etc.

Examples of the post-transition metal halide include zinc halide (for example, ZnF₂, ZnCl₂, ZnBr₂, ZnI₂, etc.), indium halide (for example, InI₃, etc.), tin halide (for example, SnI₂, etc.), etc.

Examples of the lanthanide metal halide include YbF, YbF₂, YbF₃, SmF₃, YbCl, YbCl₂, YbCl₃ SmCl₃, YbBr, YbBr₂, YbBr₃, SmBr₃, Ybl, YbI₂, YbI₃, SmI₃, and the like.

An example of the metalloid halide includes antimony halide (for example, SbCls, etc.).

Examples of the metal telluride include alkali metal telluride (for example, Li₂Te, Na₂Te, K2Te, Rb₂Te, Cs₂Te, etc.), alkaline earth metal telluride (for example, BeTe, MgTe, CaTe, SrTe, BaTe, etc.), transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal telluride (for example, ZnTe, etc.), and lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### Emission layer 130

The emission layer may be between the hole transport region 120 and the electron transport region 140.

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers of a red emission layer, a green emission layer, and a blue emission layer, in which the two or more layers contact (e.g., physically contact) each other or are separated (e.g., spaced apart) from each other to emit white light. In one or more embodiments, the emission layer may include two or more materials of a red light-emitting material, a green light-emitting material, and a blue light-emitting material, in which the two or more materials are mixed together with each other in a single layer to emit white light.

The emission layer may include a host and a dopant. The dopant may include a phosphorescent dopant, a fluorescent dopant, or a combination thereof.

The amount of the dopant in the emission layer may be from about 0.01 part by weight to about 15 parts by weight based on 100 parts by weight of the host.

In one or more embodiments, the emission layer may include a quantum dot.

In one or more embodiments, the emission layer may include a delayed fluorescence material. The delayed fluorescence material may act as a host or a dopant in the emission layer.

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

### Host

In one or more embodiments, the host may include a compound represented by Formula 301 below:

Formula 301 [Ar₃₀₁]_{xb11}-[(L₃₀₁)_{xb1}-R₃₀₁]_{xb21}

In Formula 301,
Ar₃₀₁ and L₃₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ,-Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), or -P(=O)(Q₃₀₁)(Q₃₀₂),
xb21 may be an integer from 1 to 5, and
Q₃₀₁ to Q₃₀₃ are each as described for Q₁.

For example, when xb11 in Formula 301 is 2 or more, two or more of Ar₃₀₁(s) may be linked to each other via a single bond.

In one or more embodiments, the host may include a compound represented by Formula 301-1, a compound represented by Formula 301-2, or a combination thereof: 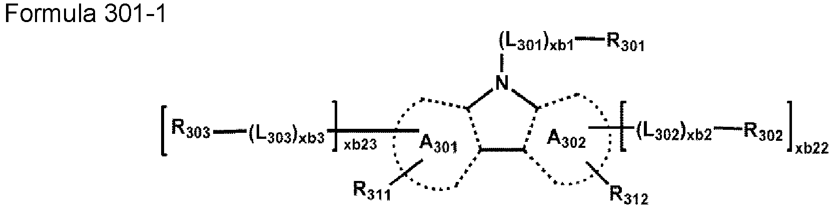 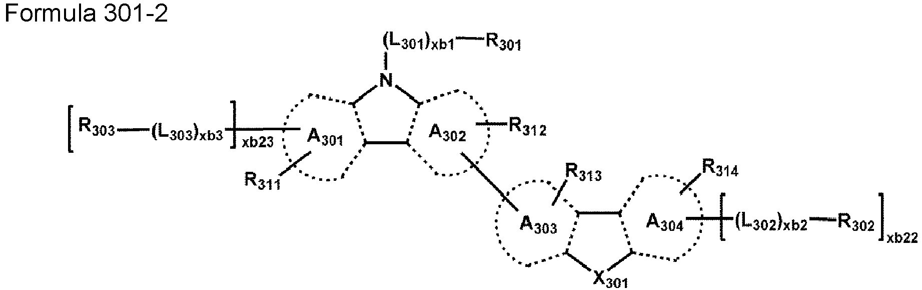
wherein, in Formula 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₆),
xb22 and xb23 may each independently be 0, 1, or 2,
L₃₀₁, xb1, and R₃₀₁ may each be as described herein,
L₃₀₂ to L₃₀₄ may each independently be as described for L₃₀₁,
xb2 to xb4 may each independently be as described for xb1, and
R₃₀₂ to R₃₀₅ and R₃₁₁ to R₃₁₄ may each be as described for R₃₀₁.

In one or more embodiments, the host may include an alkali earth metal complex, a post-transition metal complex, or a combination thereof. For example, the host may include a Be complex (for example, Compound H55), an Mg complex, a Zn complex, or a combination thereof.

In one or more embodiments, the host may include: one selected from Compounds H1 to H128; 9,10-di(2-naphthyl)anthracene (I); 2-methyl-9,10-bis(naphthalen-2-yl)anthracene (MADN); 9,10-di-(2-naphthyl)-2-t-butyl-anthracene (TBADN); 4,4'-bis(N-carbazolyl)-1,1'-biphenyl (CBP); 1,3-di-9-carbazolylbenzene (mCP); 1,3,5-tri(carbazol-9-yl)benzene (TCP); or a combination thereof:

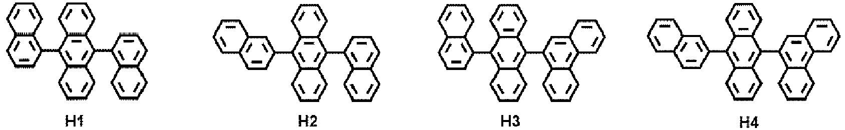

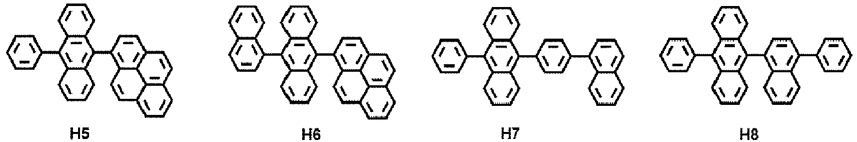

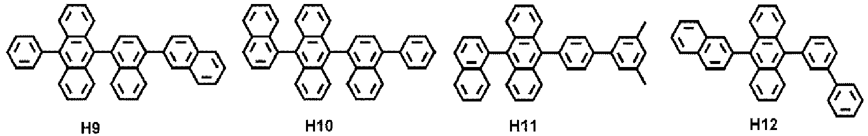

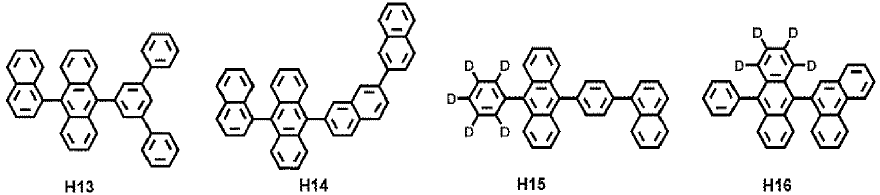

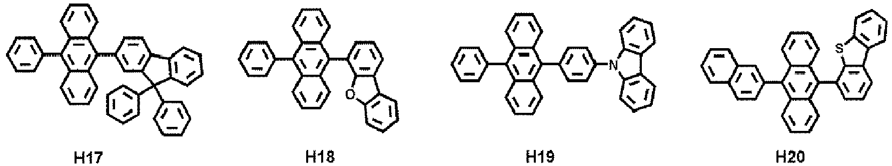

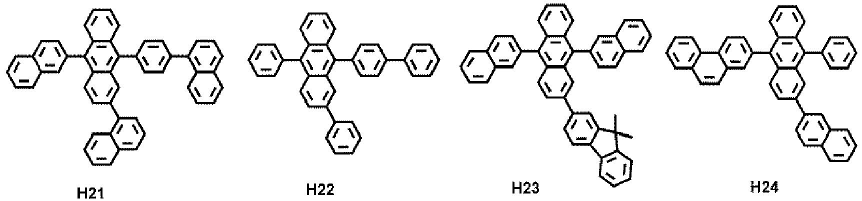

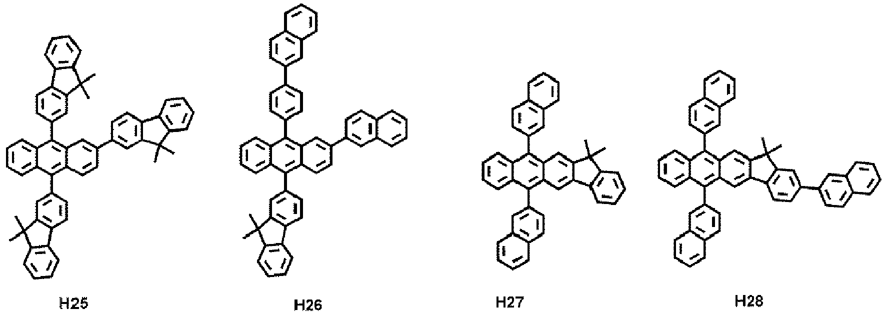

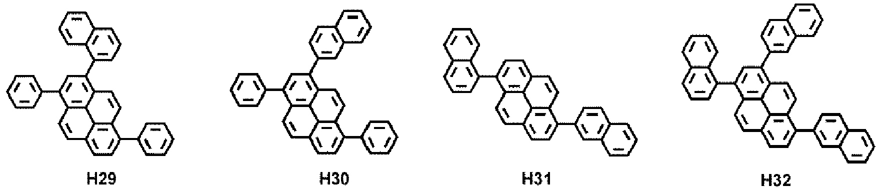

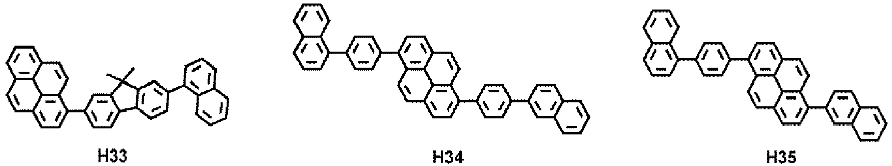

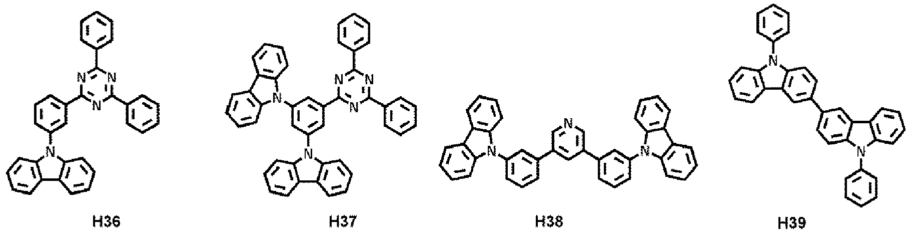

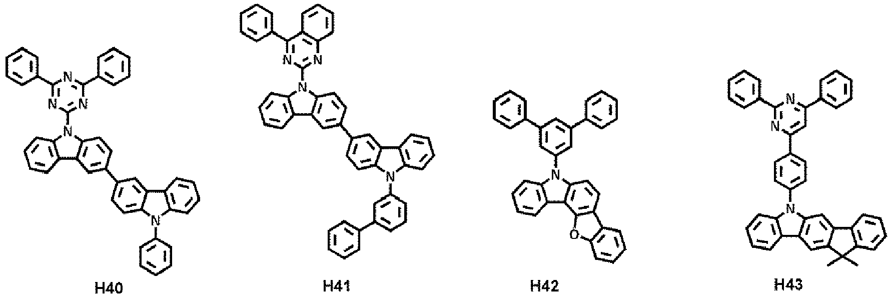

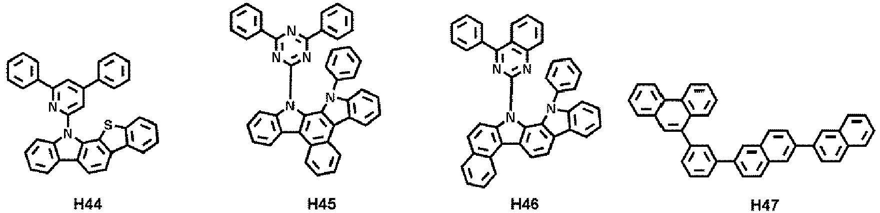

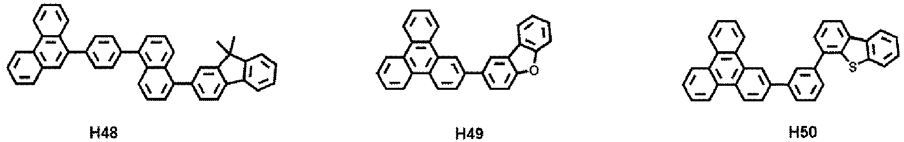

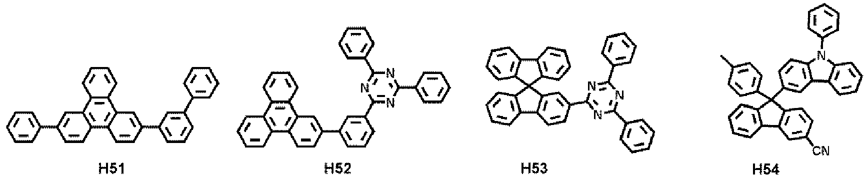

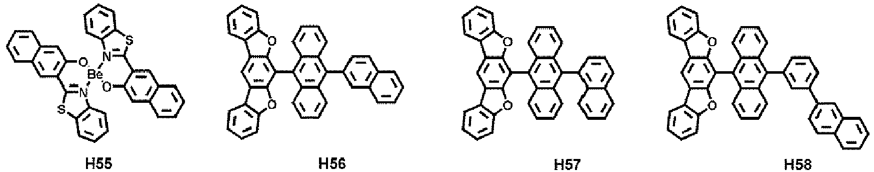

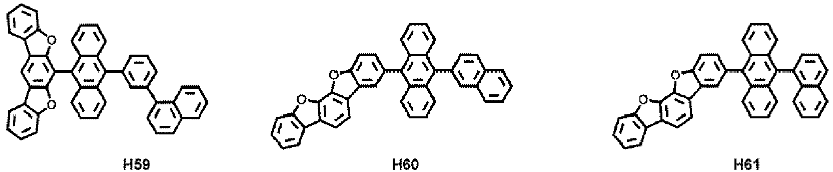

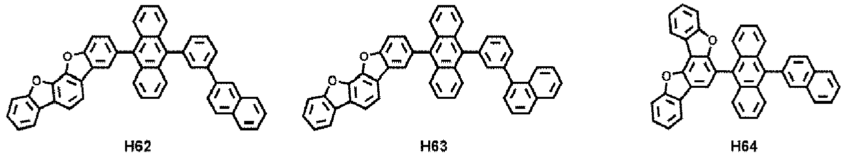

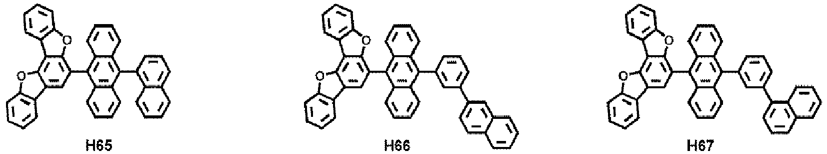

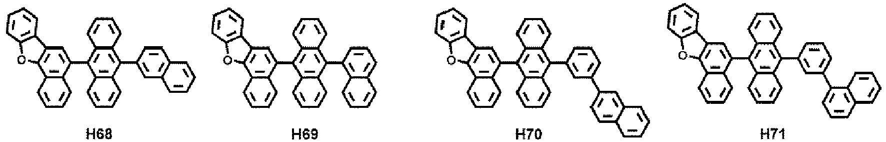

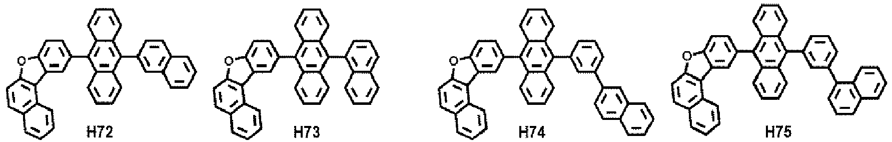

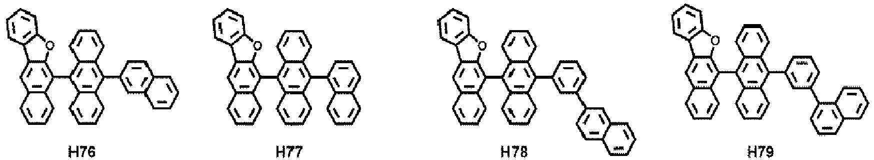

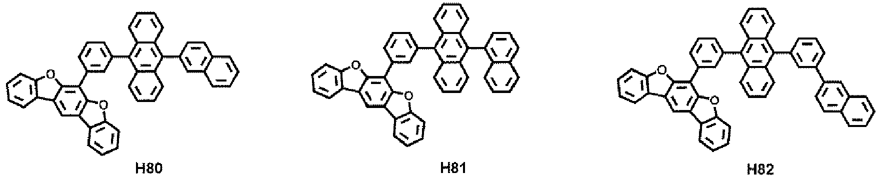

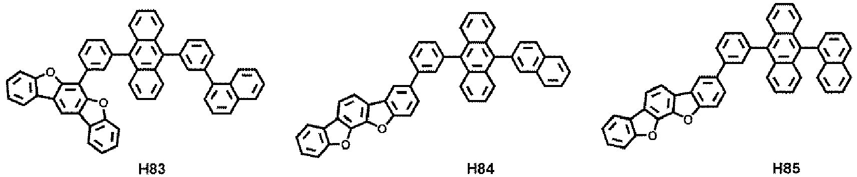

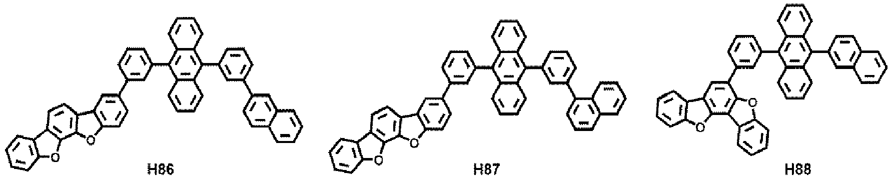

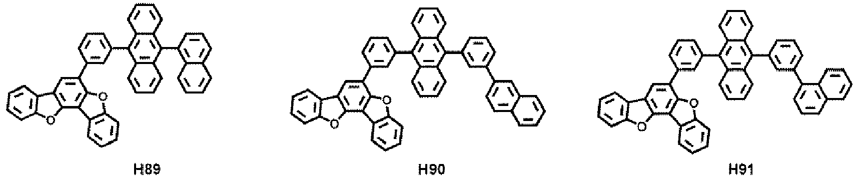

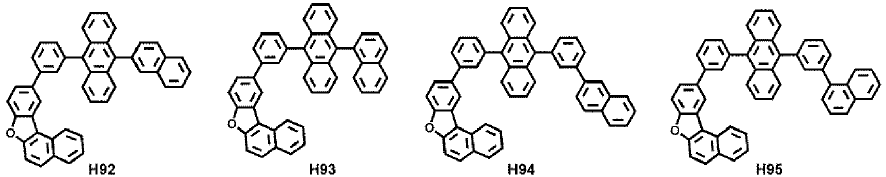

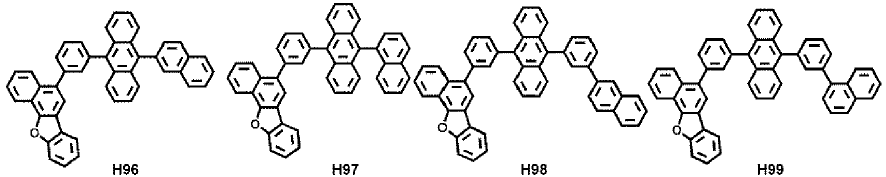

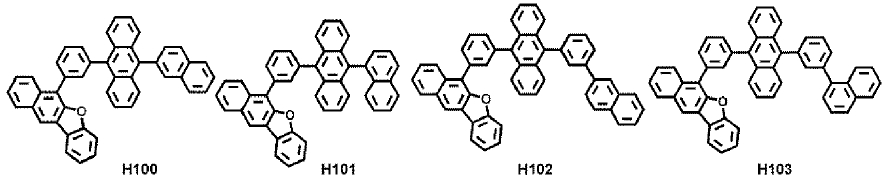

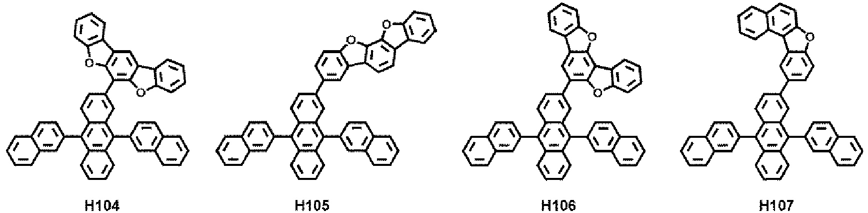

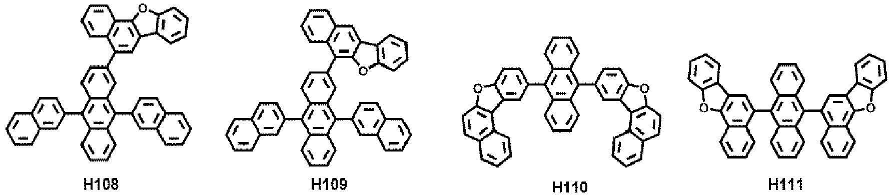

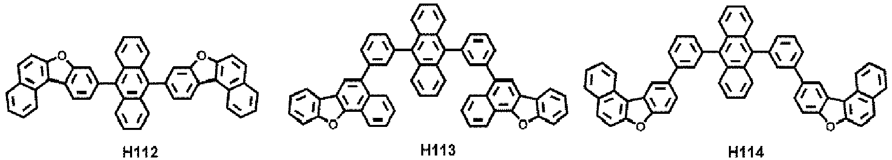

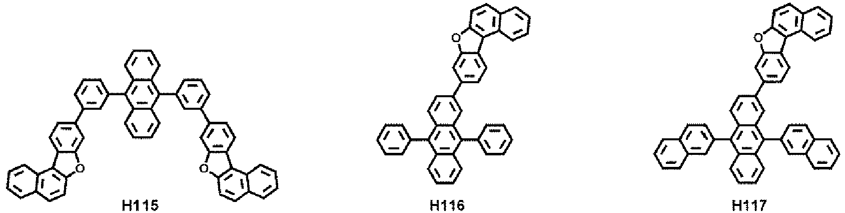

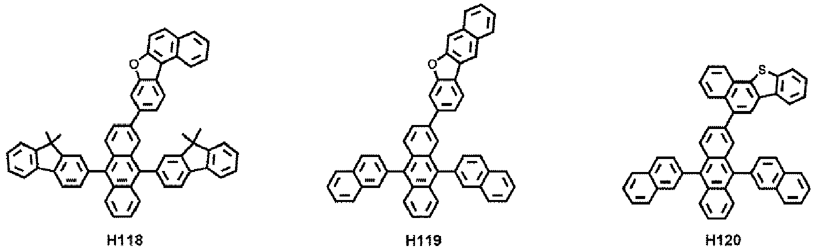

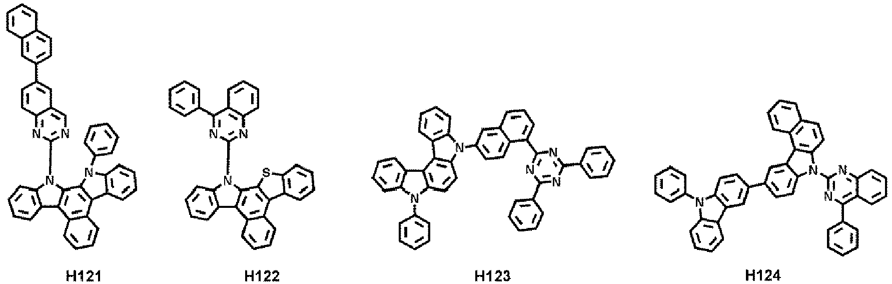

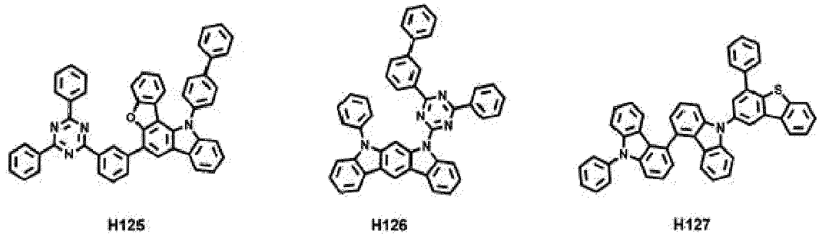

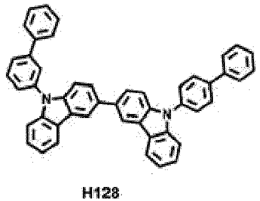

### Phosphorescent dopant

In one or more embodiments, the phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or a combination thereof.

The phosphorescent dopant may be electrically neutral.

For example, the phosphorescent dopant may include an organometallic compound represented by Formula 401:

Formula 401 M(L₄₀₁)_{xc1}(L₄₀₂)_{xc2}

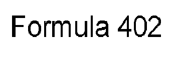

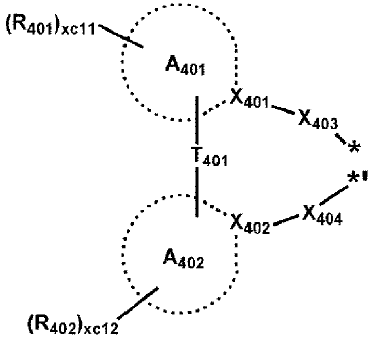

wherein, in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein when xc1 is two or more, two or more of L₄₀₁(s) may be identical to or different from each other,
L₄₀₂ may be an organic ligand, and xc2 may be 0, 1, 2, 3, or 4, and when xc2 is 2 or more, two or more of L₄₀₂(s) may be identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (for example, a covalent bond or a coordination bond (which may also be referred to as a coordinate covalent bond or a dative bond)), O, S, N(Q₄₁₃), B(Q₄₁₃), P(Q₄₁₃), C(Q₄₁₃)(Q₄₁₄), or Si(Q413)(Q414),
Q₄₁₁ to Q₄₁₄ may each be as described for Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), - S(=O)₂(Q₄₀₁), or -P(=O)(Q₄₀₁)(Q₄₀₂),
Q₄₀₁ to Q₄₀₃ may each be as described for Q₁,
xc11 and xc12 may each independently be an integer from 0 to 10, and* and *' in Formula 402 each indicate a binding site to M in Formula 401.

For example, in Formula 402, i) X₄₀₁ may be nitrogen, and X₄₀₂ may be carbon, or ii) each of X₄₀₁ and X₄₀₂ may be nitrogen.

In one or more embodiments, when xc1 in Formula 401 is 2 or more, two ring A₄₀₁(s) among two or more of L₄₀₁ may optionally be bonded to each other via T₄₀₂, which is a linking group, and two ring A₄₀₂(s) among two or more of L₄₀₁ may optionally be bonded to each other via T₄₀₃, which is a linking group (see Compounds PD1 to PD4 and PD7). T₄₀₂ and T₄₀₃ may each be as described for T₄₀₁.

L₄₀₂ in Formula 401 may be an organic ligand. For example, L₄₀₂ may include a halogen group, a diketone group (for example, an acetylacetonate group), a carboxylic acid group (for example, a picolinate group), -C(=O), an isonitrile group, -CN group, a phosphorus group (for example, a phosphine group, a phosphite group, etc.), or a combination thereof.

The phosphorescent dopant may include, for example, one selected from compounds PD1 to PD39, or a combination thereof:

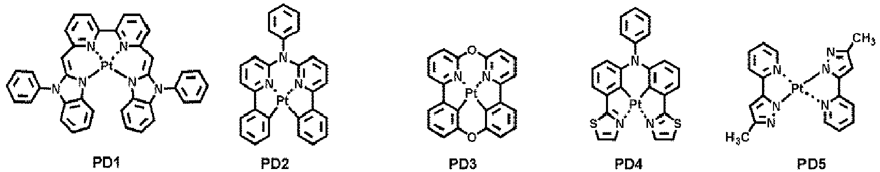

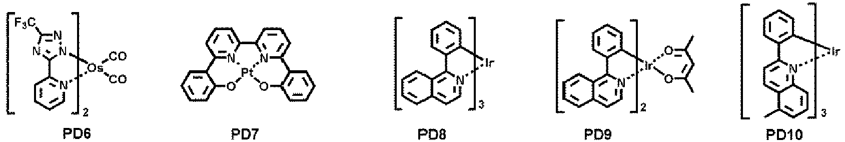

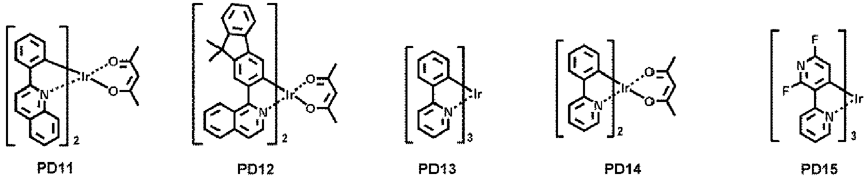

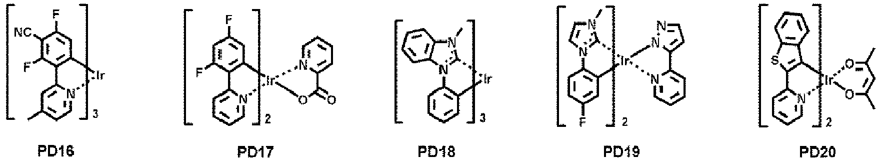

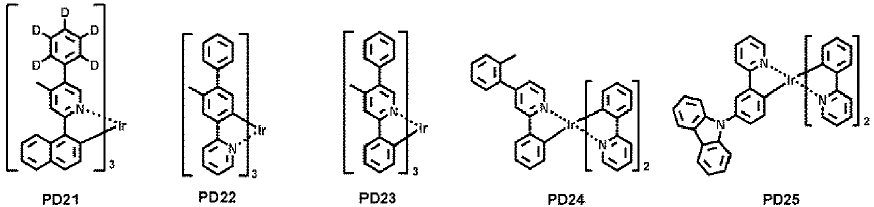

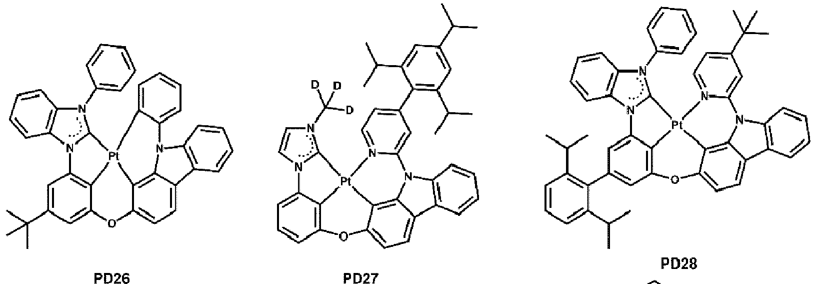

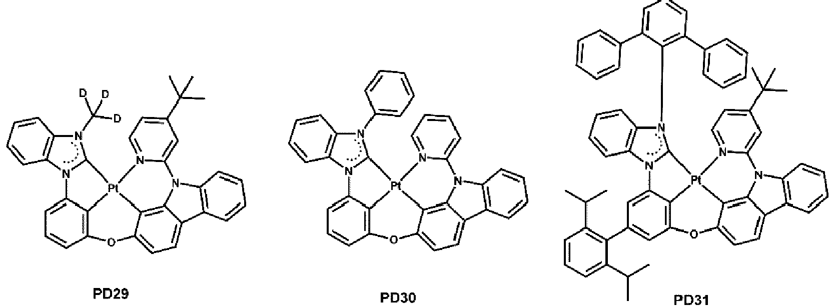

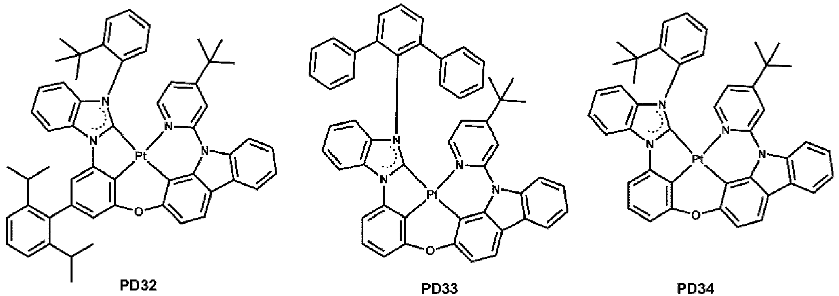

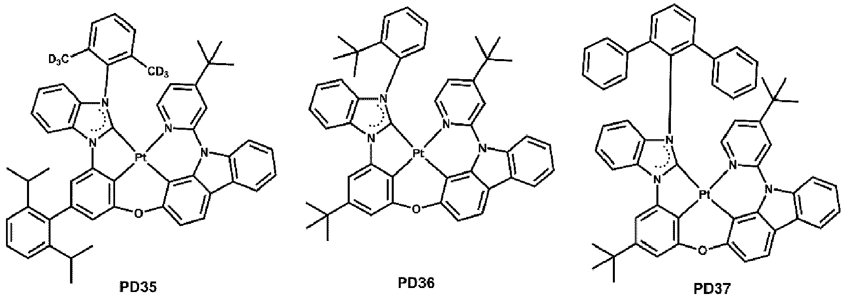

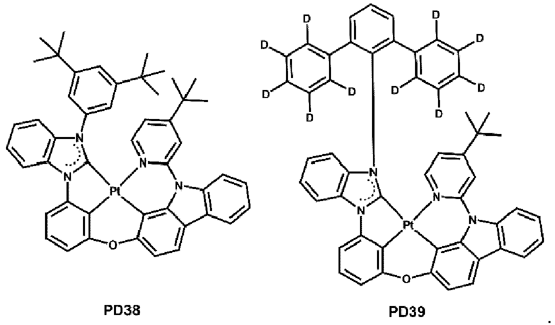

### Fluorescent dopant

The fluorescent dopant may include an amine group-containing compound, a styryl group-containing compound, or a combination thereof.

For example, the fluorescent dopant may include a compound represented by Formula 501: 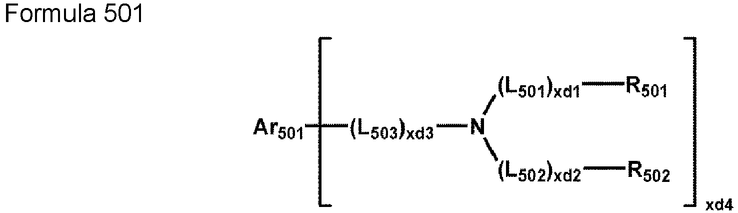
wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

For example, Ar₅₀₁ in Formula 501 may be a condensed cyclic group (for example, an anthracene group, a chrysene group, or a pyrene group) in which three or more monocyclic groups are condensed together.

In one or more embodiments, xd4 in Formula 501 may be 2.

In one or more embodiments, the fluorescent dopant may include one selected from Compounds FD1 to FD37, DPVBi, DPAVBi, or a combination thereof:

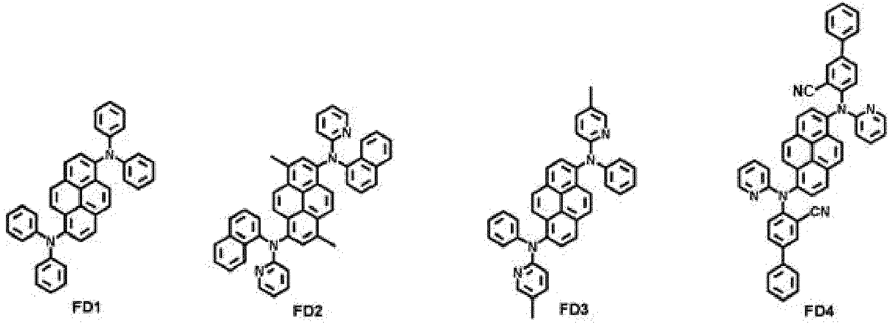

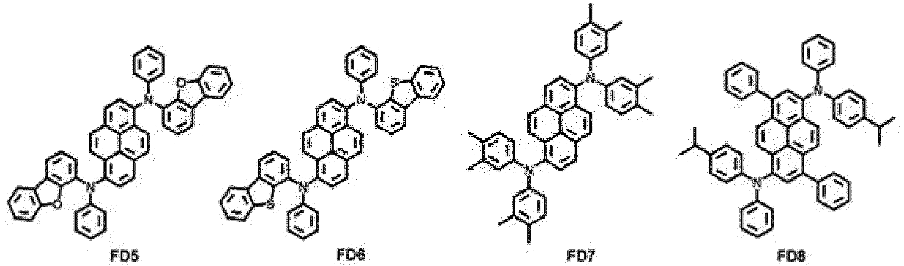

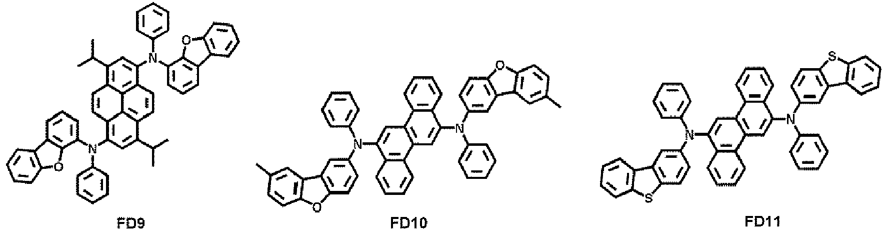

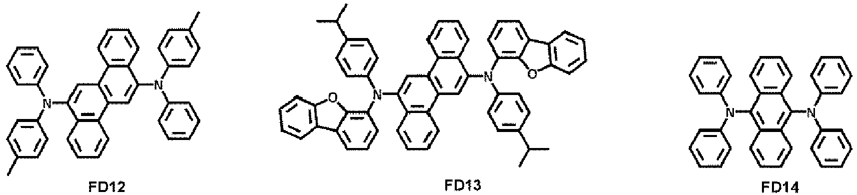

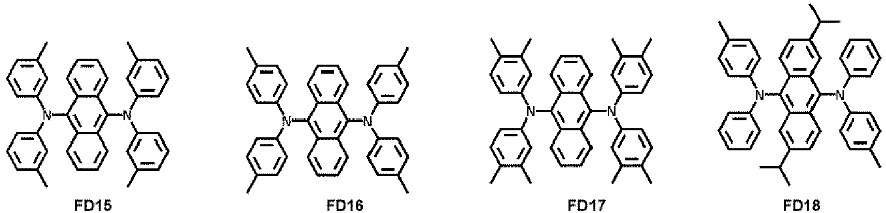

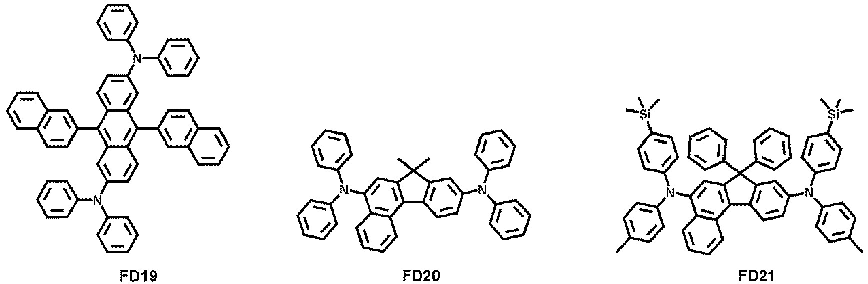

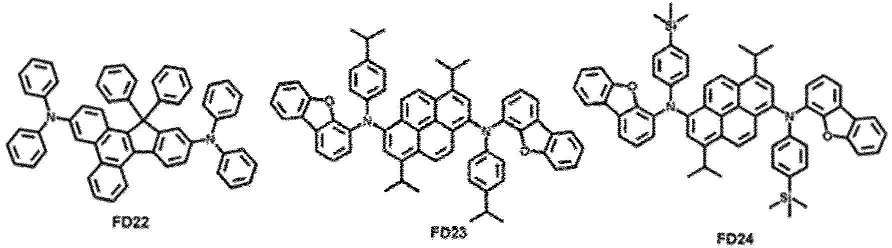

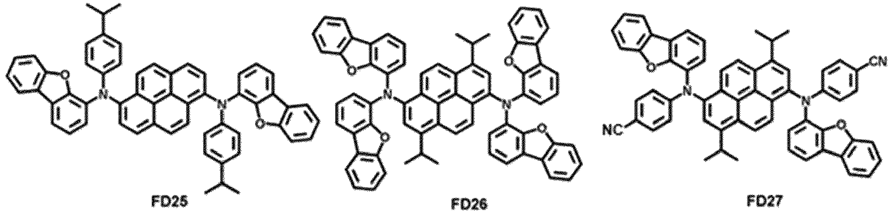

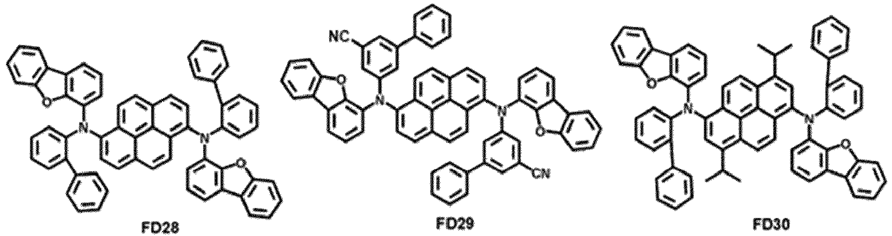

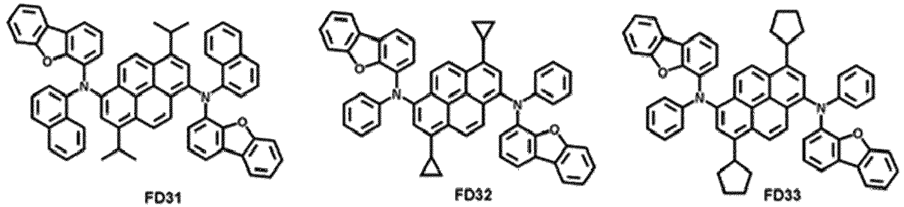

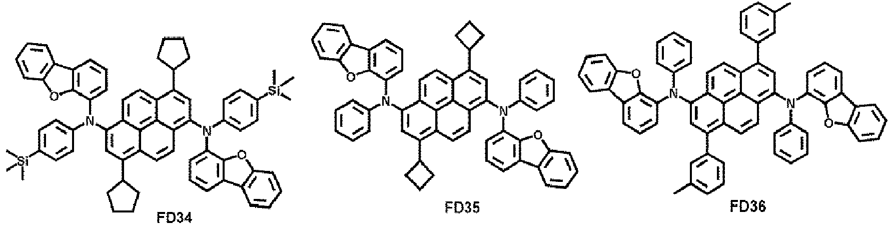

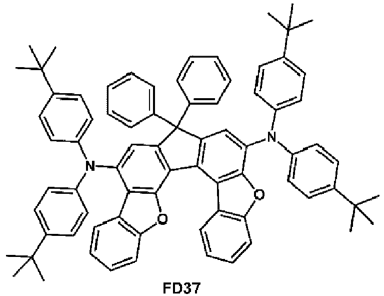

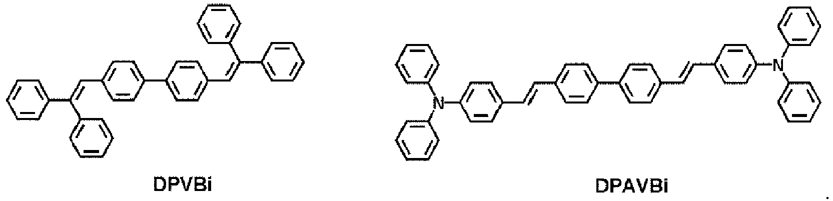

### Delayed fluorescence material

The emission layer may include a delayed fluorescence material.

In the present specification, the delayed fluorescence material may be selected from compounds capable of emitting delayed fluorescent light based on a delayed fluorescence emission mechanism.

The delayed fluorescence material included in the emission layer may act as a host or a dopant depending on the type (or kind) of other materials included in the emission layer.

In one or more embodiments, the difference between the triplet energy level (eV) of the delayed fluorescence material and the singlet energy level (eV) of the delayed fluorescence material may be greater than or equal to 0 eV and less than or equal to 0.5 eV. When the difference between the triplet energy level (eV) of the delayed fluorescence material and the singlet energy level (eV) of the delayed fluorescence material satisfies the above-described range, up-conversion from the triplet state to the singlet state of the delayed fluorescence materials may effectively occur, and thus, the luminescence efficiency of the light-emitting device 10 may be improved.

For example, the delayed fluorescence material may include i) a material including at least one electron donor (for example, a π electron-rich C₃-C₆₀ cyclic group, such as a carbazole group) and at least one electron acceptor (for example, a sulfoxide group, a cyano group, or a π electron-deficient nitrogen-containing C₁-C₆₀ cyclic group), and ii) a material including a C₈-C₆₀ polycyclic group in which two or more cyclic groups are condensed together while sharing boron (B).

Examples of the delayed fluorescence material may include at least one selected from Compounds DF1 to DF14:

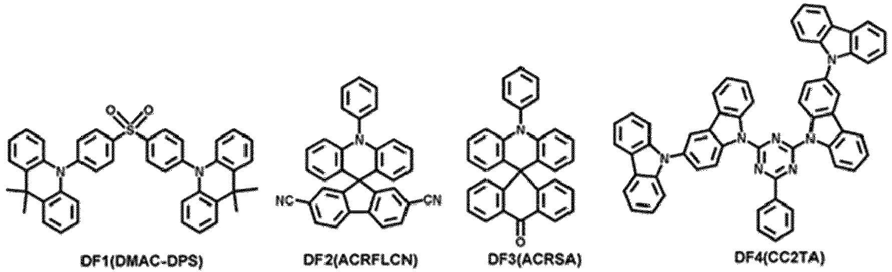

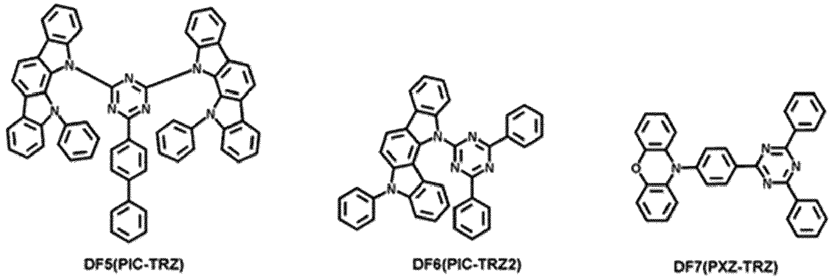

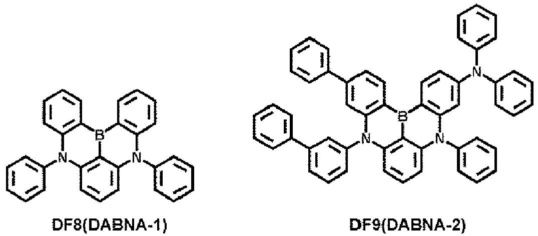

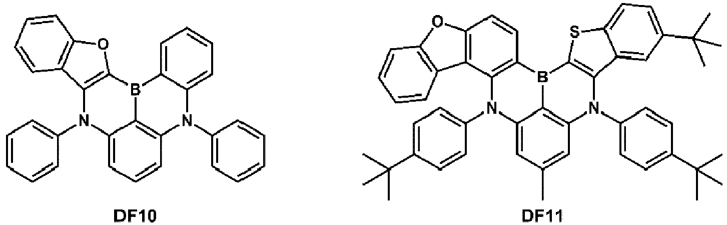

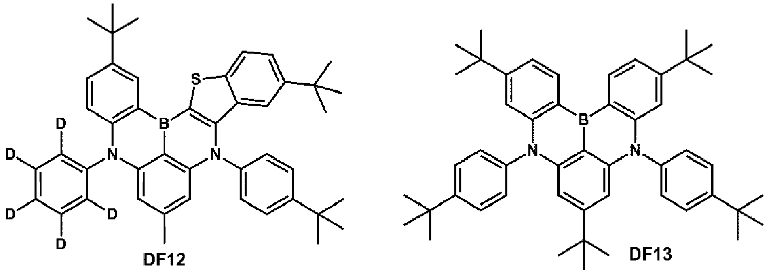

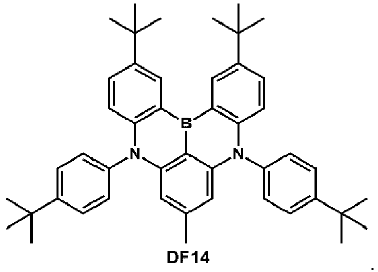

### Quantum dot

The emission layer may include a quantum dot.

The term "quantum dots" as used herein refers to crystals of a semiconductor compound, and may include any suitable material capable of emitting light of various suitable emission wavelengths according to the size of the crystals.

A diameter of the quantum dot may be, for example, in a range of about 1 nm to about 10 nm.

The quantum dot may be synthesized by a wet chemical process, a metal organic chemical vapor deposition process, a molecular beam epitaxy process, and/or any suitable process similar thereto.

The wet chemical process is a method including mixing together a precursor material with an organic solvent and then growing a quantum dot particle crystal. When the crystal grows, the organic solvent naturally acts as a dispersant coordinated on the surface of the quantum dot crystal and controls the growth of the crystal so that the growth of quantum dot particles can be controlled through a process which costs lower, and is easier than vapor deposition methods, such as metal organic chemical vapor deposition (MOCVD), and/or molecular beam epitaxy (MBE).

The quantum dot may include Group II-VI semiconductor compounds, Group III-V semiconductor compounds, Group III-VI semiconductor compounds, Group I-III-VI semiconductor compounds, Group IV-VI semiconductor compounds, a Group IV element or compound, or a combination thereof.

Examples of the Group II-VI semiconductor compound may include: binary compound, such as CdS, CdSe, CdTe, ZnS, ZnSe, ZnTe, ZnO, HgS, HgSe, HgTe, MgSe, and/or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, and/or MgZnS; a quaternary compound, such as CdZnSeS, CdZnSeTe, CdZnSTe, CdHgSeS, CdHgSeTe, CdHgSTe, HgZnSeS, HgZnSeTe, and/or HgZnSTe; or a combination thereof.

Examples of the Group III-V semiconductor compound may include: a binary compound, such as GaN, GaP, GaAs, GaSb, AlN, AlP, AlAs, AlSb, InN, InP, InAs, and/or InSb; a ternary compound, such as GaNP, GaNAs, GaNSb, GaPAs, GaPSb, AlNP, AlNAs, AlNSb, AlPAs, AlPSb, InGaP, InNP, InAlP, InNAs, InNSb, InPAs, and/or InPSb; a quaternary compound, such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, and/or InAlPSb; or a combination thereof. In one or more embodiments, the Group III-V semiconductor compound may further include a Group II element. Examples of the Group III-V semiconductor compound further including a Group II element are InZnP, InGaZnP, InAlZnP, etc.

Examples of the Group III-VI semiconductor compound are: a binary compound, such as GaS, GaSe, Ga₂Se₃, GaTe, InS, InSe, In₂S₃, In₂Se₃, and/or InTe; a ternary compound, such as InGaS₃, and/or InGaSe₃; and a combination thereof.

Examples of the group I-III-VI semiconductor compound may include a ternary compound such as AgInS, AgInS₂, CuInS, CuInS₂, CuGaO₂, AgGaO₂, AgAlO₂, etc., a quaternary compound such as AgInGaS, or a combination thereof.

Examples of the Group IV-VI semiconductor compound are: a binary compound, such as SnS, SnSe, SnTe, PbS, PbSe, and/or PbTe; a ternary compound, such as SnSeS, SnSeTe, SnSTe, PbSeS, PbSeTe, PbSTe, SnPbS, SnPbSe, and/or SnPbTe; a quaternary compound, such as SnPbSSe, SnPbSeTe, and/or SnPbSTe; or a combination thereof.

The Group IV element or compound may include: a single element compound, such as Si and/or Ge; a binary compound, such as SiC and/or SiGe; or a combination thereof.

Each element included in a multi-element compound such as the binary compound, the ternary compound, and the quaternary compound may be present at a uniform concentration or non-uniform concentration in a particle.

In one or more embodiments, the quantum dot may have a single structure in which the concentration of each element in the quantum dot is uniform (e.g., substantially uniform), or a core-shell dual structure. For example, the material included in the core and the material included in the shell may be different from each other.

The shell of the quantum dot may act as a protective layer that prevents or reduces chemical degeneration of the core to maintain semiconductor characteristics, and/or as a charging layer that imparts electrophoretic characteristics to the quantum dot. The shell may be a single layer or a multi-layer. The interface between the core and the shell may have a concentration gradient in which the concentration of an element existing in the shell decreases along a direction toward the center of the core.

Examples of the shell of the quantum dot may include an oxide of metal, metalloid, and/or non-metal, a semiconductor compound, and a combination thereof. Examples of the oxide of metal, metalloid, or non-metal include a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO; a ternary compound, such as MgAl₂O₄, CoFe₂O₄, NiFe₂O₄, and/or CoMn₂O₄; and a combination thereof. Examples of the semiconductor compound include, as described herein, a Group II-VI semiconductor compound; a Group III-V semiconductor compound; a Group III-VI semiconductor compound; a Group I-III-VI semiconductor compound; a Group IV-VI semiconductor compound; and a combination thereof. For example, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or a combination thereof.

A full width at half maximum (FWHM) of the emission wavelength spectrum of the quantum dot may be about 45 nm or less, for example, about 40 nm or less, for example, about 30 nm or less, and within these ranges, color purity and/or color reproducibility may be increased. In addition, because the light emitted through the quantum dot is emitted in all (e.g., substantially all) directions, the wide viewing angle may be improved.

In addition, the quantum dot may be in the form of a spherical particle, a pyramidal particle, a multi-arm particle, a cubic nanoparticle, a nanotube particle, a nanowire particle, a nanofiber particle, and/or a nanoplate particle.

Because the energy band gap may be adjusted by controlling the size of the quantum dot, light having various suitable wavelength bands may be obtained from the quantum dot emission layer. Accordingly, by using quantum dots of different sizes, a light-emitting device that emits light of various suitable wavelengths may be implemented. In one or more embodiments, the size of the quantum dot may be selected to emit red, green and/or blue light. In addition, the size of the quantum dot may be configured to emit white light by combination of light of various suitable colors.

### Electron transport region 140

The electron transport region may have: i) a single-layered structure consisting of a single layer consisting of a single material, ii) a single-layered structure consisting of a single layer consisting of a plurality of different materials, or iii) a multi-layered structure including a plurality of layers including different materials.

The electron transport region may include a buffer layer, a hole blocking layer, an electron control layer, an electron transport layer, an electron injection layer, or a combination thereof.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, the constituting layers of each structure being sequentially stacked from an emission layer.

In one or more embodiments, the electron transport region (for example, the buffer layer, the hole blocking layer, the electron control layer, or the electron transport layer in the electron transport region) may include a metal-free compound including at least one π electron-deficient nitrogen-containing C₁-C₆₀ cyclic group.

For example, the electron transport region may include a compound represented by Formula 601 below:

Formula 601 [Ar₆₀₁]ₓₑ₁₁-[(L₆₀₁)ₓₑ₁-R₆₀₁]ₓₑ₂₁

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or-P(=O)(Q₆₀₁)(Q₆₀₂),
Q₆₀₁ to Q₆₀₃ may each be as described for Q₁,
xe21 may be 1, 2, 3, 4, or 5,
at least one selected from Ar₆₀₁, L₆₀₁, and R₆₀₁ may each independently be a π electron-deficient nitrogen-containing C₁-C₆₀ cyclic group unsubstituted or substituted with at least one R₁₀ₐ.

For example, when xe11 in Formula 601 is 2 or more, two or more of Ar₆₀₁(s) may be linked to each other via a single bond.

In other embodiments, Ar₆₀₁ in Formula 601 may be an anthracene group unsubstituted or substituted with at least one R₁₀ₐ.

In other embodiments, the electron transport region may include a compound represented by Formula 601-1: 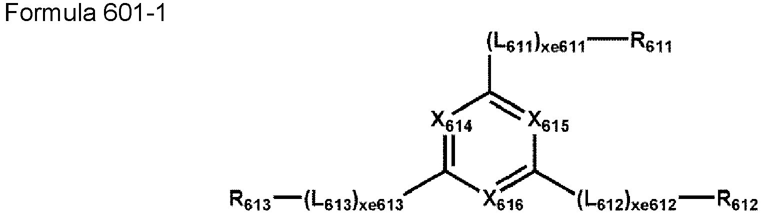
wherein, in Formula 601-1,
X₆₁₄ may be N or C(R₆₁₄), X₆₁₆ may be N or C(R₆₁₆), X₆₁₆ may be N or C(R₆₁₆), and at least one selected from X₆₁₄ to X₆₁₆ may be N,
L₆₁₁ to L₆₁₃ may each be as described for L₆₀₁,
xe611 to xe613 may each be as described for xe1,
R₆₁₁ to R₆₁₃ may each be as described for R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, xe1 and xe611 to xe613 in Formulae 601 and 601-1 may each independently be 0, 1, or 2.

The electron transport region may include one selected from Compounds ET1 to ET45, 2,9-dimethyl-4,7-diphenyl-1,10-phenanthroline (BCP), 4,7-diphenyl-1,10-phenanthroline (Bphen), Alq₃, BAlq, TAZ, NTAZ, or a combination thereof:

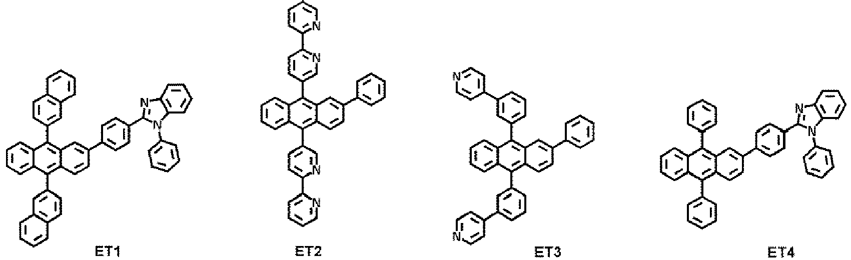

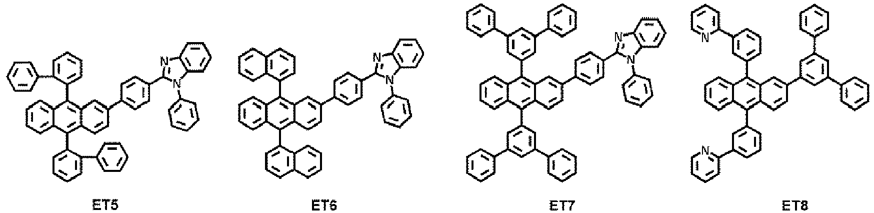

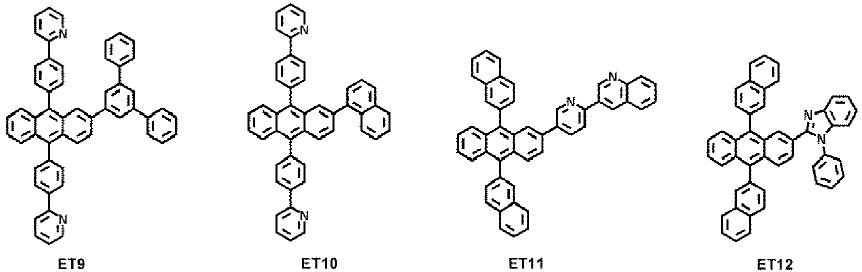

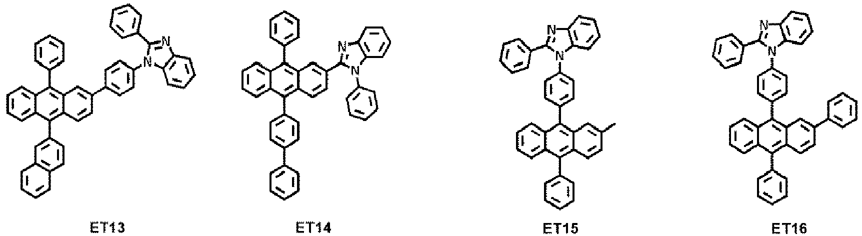

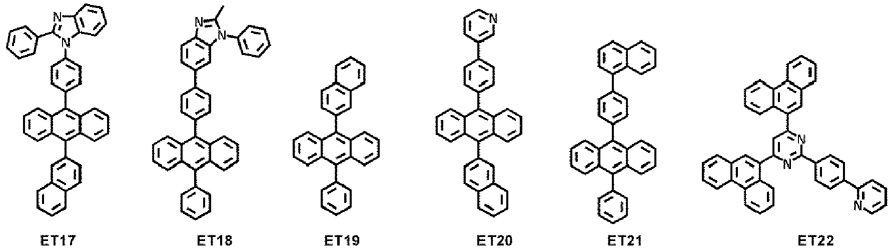

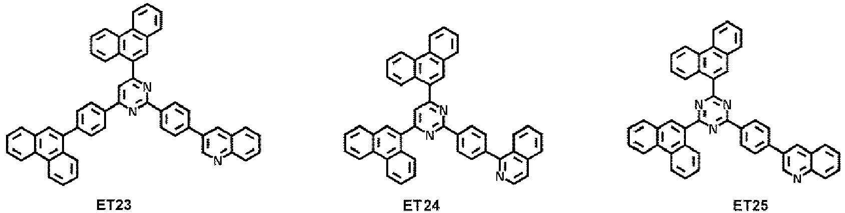

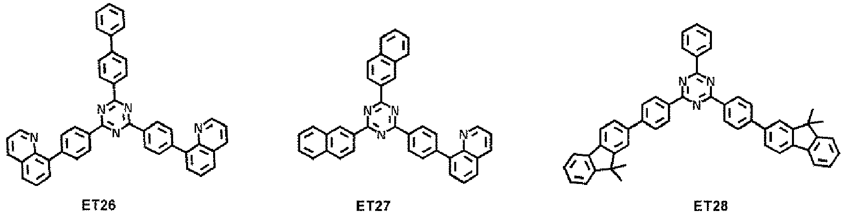

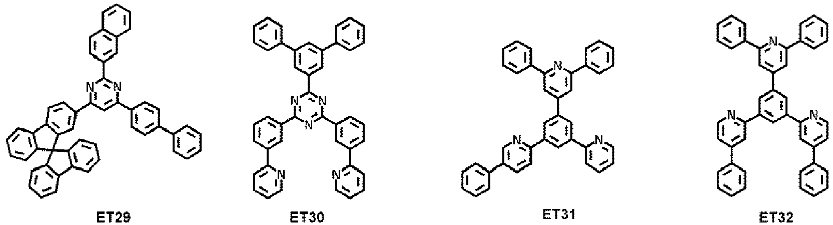

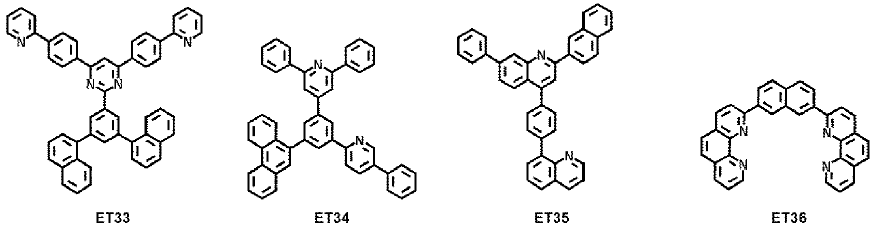

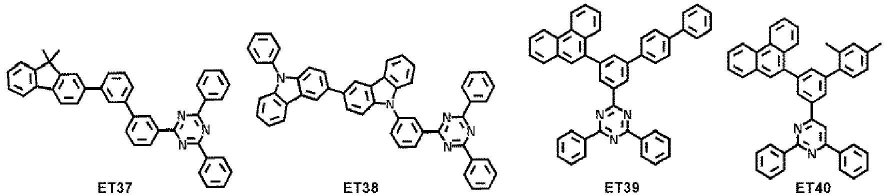

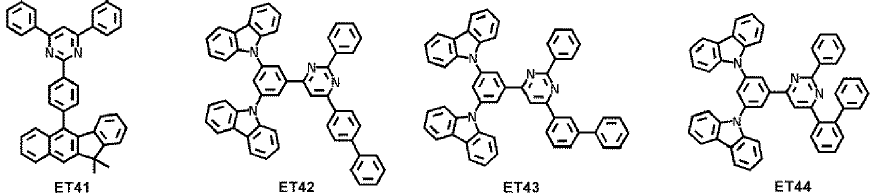

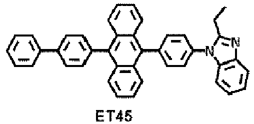

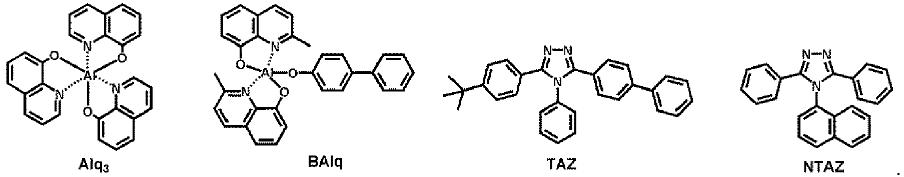

A thickness of the electron transport region may be from about 100 Å to about 5,000 Å, for example, about 160 Å to about 4,000 Å. When the electron transport region includes a buffer layer, a hole blocking layer, an electron control layer, an electron transport layer, or a combination thereof, the thickness of the buffer layer, the hole blocking layer, or the electron control layer may each independently be from about 20 Å to about 1000 Å, for example, about 30 Å to about 300 Å, and the thickness of the electron transport layer may be from about 100 Å to about 1000 Å, for example, about 150 Å to about 500 Å. When the thickness of the buffer layer, the hole blocking layer, the electron control layer, the electron transport layer, and/or the electron transport region are within these ranges, suitable or satisfactory electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or a combination thereof. The metal ion of an alkali metal complex may include a Li ion, a Na ion, a K ion, a Rb ion, or a Cs ion, and the metal ion of an alkaline earth metal complex may include a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or a combination thereof.

For example, the metal-containing material may include a Li complex. The Li complex may include, for example, Compound ET-D1 (LiQ) and/or ET-D2:

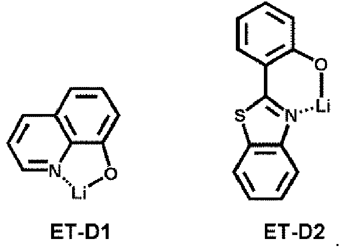

The electron transport region may include an electron injection layer that facilitates the injection of electrons from the second electrode 150. The electron injection layer may directly contact (e.g., physically contact) the second electrode 150.

The electron injection layer may have: i) a single-layered structure consisting of a single layer consisting of a single material, ii) a single-layered structure consisting of a single layer consisting of a plurality of different materials, or iii) a multi-layered structure including a plurality of layers including different materials.

The electron injection layer may include an alkali metal, alkaline earth metal, a transition metal, a post-transition metal, a lanthanide metal, an alkali metal-containing compound, an alkaline earth metal-containing compound, a transition metal-containing compound, a post-transition metal-containing compound, a lanthanide metal-containing compound, an alkali metal complex, an alkaline earth metal complex, a transition metal complex, a post-transition metal complex, a lanthanide metal complex, or a combination thereof.

The alkali metal may include Li, Na, K, Rb, Cs, or a combination thereof. The alkaline earth metal may include Mg, Ca, Sr, Ba, or a combination thereof. The transition metal may include Sc, Y, Cu, Ag, Au or a combination thereof. The post-transition metal may include Al, Ga, In, Sn, or a combination thereof. The lanthanide metal may include La, Ce, Sm, Gd, Tb, Yb, or a combination thereof.

An alkali metal-containing compound, an alkaline earth metal-containing compound, a transition metal-containing compound, a post-transition metal-containing compound and a lanthanide metal-containing compound may be oxides, halides, (for example, fluoride, chloride, bromide, iodide, etc.), tellurides, or a combination thereof of each of the alkali metal, the alkaline earth metal, the transition metal, the post-transition metal, and the lanthanide metal.

The alkali metal-containing compound may include: alkali metal oxides, such as Li₂O, Cs₂O, and/or K₂O; alkali metal halides, such as LiF, NaF, CsF, KF, Lil, Nal, Csl, and/or KI; or a combination thereof. The alkaline earth metal-containing compound may include an alkaline earth metal oxide, such as BaO, SrO, CaO, BaₓSr₁₋ₓO (x is a real number satisfying the condition of 0<x<1), BaₓCa₁₋ₓO (x is a real number satisfying the condition of 0<x<1), and/or the like. The transition metal-containing compound may include ScF₃, Sc₂O₃, ScI₃, Y₂O₃, etc. The lanthanide metal-containing compound may include YbF₃, Ce₂O₃, GdF₃, TbF₃, YbI₃, TbI₃, or a combination thereof. The lanthanide metal-containing compound may include a lanthanide metal telluride such as LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, etc.

The alkali metal complex, the alkaline earth metal complex, the transition metal complex, the post-transition metal complex, and the lanthanide metal complex may include i) one of ions of the alkali metal, the alkaline earth metal, the transition metal, the post-transition metal, and the lanthanide metal, and ii) as a ligand linked to the metal ion, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxydiphenyloxadiazole, a hydroxydiphenylthiadiazole, a hydroxyphenylpyridine, a hydroxyphenyl benzimidazole, a hydroxyphenylbenzothiazole, a bipyridine, a phenanthroline, a cyclopentadiene, or a combination thereof.

The electron injection layer may include an alkali metal, an alkaline earth metal, a transition metal, a post-transition metal, a lanthanide metal, an alkali metal-containing compound, an alkaline earth metal-containing compound, a transition metal-containing compound, a post-transition metal-containing compound, a lanthanide metal-containing compound, an alkali metal complex, an alkaline earth metal complex, a transition metal complex, a post-transition metal complex, a lanthanide metal complex, or a combination thereof, and/or may further include an organic material (for example, a compound represented by Formula 601).

In one or more embodiments, the electron injection layer may consist of i) an alkali metal-containing compound (for example, alkali metal halide), ii) a) a lanthanide metal, iii) a) an alkali metal-containing compound (for example, an alkali metal halide), b) an alkaline earth metal, c) a lanthanide metal, or a combination thereof. For example, the electron injection layer may be a Yb:Mg:Ag co-deposited layer, a Yb:Mg:Au co-deposited layer, a Yb:Mg:Al co-deposited layer, a Yb:Mg co-deposited layer, a LiF:Mg:Ag co-deposited layer, a LiF:Mg:Au co-deposited layer, a LiF:Mg:Al co-deposited layer, a KI:Yb co-deposited layer, a Rbl:Yb co-deposited layer, a LiF:Yb co-deposited layer, etc.

When the electron injection layer further includes the organic material, the alkali metal, the alkaline earth metal, the transition metal, the post-transition metal, the lanthanide metal, the alkali metal-containing compound, the alkaline earth metal-containing compound, the transition metal-containing compound, the post-transition metal-containing compound, the lanthanide metal-containing compound, the alkali metal complex, the alkaline earth metal complex, the transition metal complex, the post-transition metal complex, the lanthanide metal complex, or a combination thereof may be homogeneously or non-homogeneously dispersed in a matrix including the organic material.

A thickness of the electron injection layer may be in a range of about 1 Å to about 100 Å, and, for example, about 3 Å to about 90 Å. When the thickness of the electron injection layer is within the ranges described above, suitable or satisfactory electron injection characteristics may be obtained without a substantial increase in driving voltage.

### Second electrode 150

The second electrode 150 may be on the electron transport region 140. The second electrode 150 may be a cathode, which is an electron injection electrode, and a material for forming the second electrode 150 may include a metal, an alloy, an electrically conductive compound, or a combination thereof, each having a low-work function.

The material for forming the second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or a combination thereof. The second electrode 150 may be a transmissive electrode, a semi-transmissive electrode, or a reflective electrode.

The second electrode 150 may have a single-layered structure or a multi-layered structure including a plurality of layers.

### Capping layer

A first capping layer may be outside the first electrode 110, and/or a second capping layer may be outside the second electrode 150. In one or more embodiments, the light-emitting device 10 may have a structure in which the first capping layer, the first electrode 110, the hole transport region 120, the emission layer 130, the electron transport region 140, and the second electrode 150 are sequentially stacked in the stated order, a structure in which the first electrode 110, the hole transport region 120, the emission layer 130, the electron transport region 140, the second electrode 150, and the second capping layer are sequentially stacked in the stated order, or a structure in which the first capping layer, the first electrode 110, the hole transport region 120, the emission layer 130, the electron transport region 140, the second electrode 150, and the second capping layer are sequentially stacked in the stated order.

Light generated in the emission layer 130 of the light-emitting device 10 may be extracted toward the outside through the first electrode 110, which is a semi-transmissive electrode or a transmissive electrode, and the first capping layer. In one or more embodiments, light generated in the emission layer 130 of the light-emitting device 10 may be extracted toward the outside through the second electrode 150, which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the luminescence efficiency of the light-emitting device 10 may be improved.

Each of the first capping layer and the second capping layer may include a material having a refractive index of 1.6 or more (at a wavelength of 589 nm).

The first capping layer and the second capping layer may each independently be an organic capping layer including an organic material, an inorganic capping layer including an inorganic material, or an organic-inorganic composite capping layer including an organic material and an inorganic material.

At least one selected from the first capping layer and the second capping layer may each independently include carbocyclic compounds, heterocyclic compounds, amine group-containing compounds, porphine derivatives, phthalocyanine derivatives, naphthalocyanine derivatives, alkali metal complexes, alkaline earth metal complexes, or a combination thereof. Optionally, the carbocyclic compound, the heterocyclic compound, and the amine group-containing compound may be substituted with a substituent including O, N, S, Se, Si, F, Cl, Br, I, or a combination thereof. In one or more embodiments, at least one selected from the first capping layer and the second capping layer may each independently include an amine group-containing compound.

For example, at least one selected from the first capping layer and the second capping layer may each independently include a compound represented by Formula 201, a compound represented by Formula 202, or a combination thereof.

In one or more embodiments, at least one selected from the first capping layer and the second capping layer may each independently include one selected from Compounds HT28 to HT33, one selected from Compounds CP1 to CP6, β-NPB, or a combination thereof:

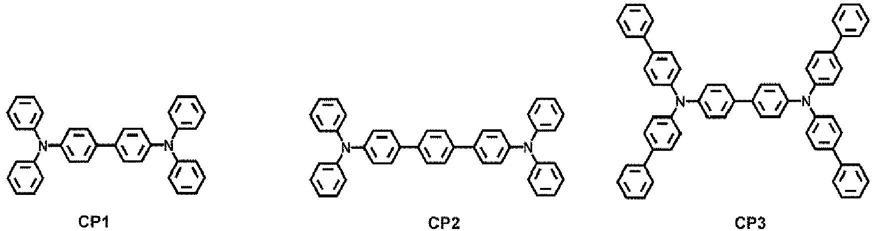

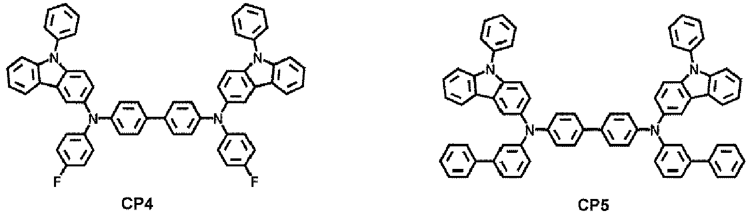

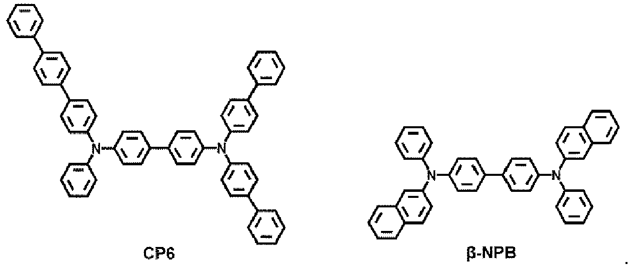

### Film

The electronic apparatus including the light-emitting device 10 may further include a film. The film may be, for example, an optical member (or a light control means) (for example, a color filter, a color conversion member, a capping layer, a light extraction efficiency enhancement layer, a selective light absorbing layer, a polarizing layer, a quantum dot-containing layer, etc.), a light-blocking member (for example, a light reflective layer, a light absorbing layer, etc.), and/or a protective member (for example, an insulating layer, a dielectric layer, etc.).

### Electronic apparatus

The light-emitting device may be included in various suitable electronic apparatuses. For example, the electronic apparatus including the light-emitting device may be a display apparatus, an authentication apparatus, etc.

The electronic apparatus (for example, a display apparatus) may further include, in addition to the light-emitting device, i) a color filter, ii) a color-conversion layer, or iii) a color filter and a color-conversion layer. The color filter and/or the color conversion layer may be in at least one direction in which light emitted from the light-emitting device travels. For example, the light emitted from the light-emitting device may be blue light or white light. For additional details of the light-emitting device, related description provided above may be referred to. In one or more embodiments, the color conversion layer may include a quantum dot. The quantum dot may be, for example, a quantum dot as described herein.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel defining film may be located among the subpixel areas to define each of the subpixel areas.

The color filter may further include a plurality of color filter areas and light-shielding patterns located among the color filter areas, and the color conversion layer may further include a plurality of color conversion areas and light-shielding patterns located among the color conversion areas.

The plurality of color filter areas (or the plurality of color conversion areas) may include a first area that emits a first color light, a second area that emits a second color light, and/or a third area that emits a third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dots. In one or more embodiments, the first area may include a red quantum dot, the second area may include a green quantum dot, and the third area may not include a quantum dot. For additional details of the quantum dot, related descriptions provided herein may be referred to. The first area, the second area, and/or the third area may each include a scatterer (e.g., a light scatterer).

For example, the light-emitting device may emit a first light, the first area may absorb the first light to emit a first-first color light, the second area may absorb the first light to emit a second-first color light, and the third area may absorb the first light to emit a third-first color light. In this regard, the first-first color light, the second-first color light, and the third-first color light may have different maximum emission wavelengths. In one or more embodiments, the first light may be blue light, the first-first color light may be red light, the second-first color light may be green light, and the third-first color light may be blue light.

The electronic apparatus may further include a TFT, in addition to the light-emitting device as described above. The TFT may include a source electrode, a drain electrode, and an activation layer, wherein any one selected from the source electrode and the drain electrode may be electrically connected to any one selected from the first electrode and the second electrode of the light-emitting device.

The TFT may further include a gate electrode, a gate insulating film, and/or the like.

The activation layer may include crystalline silicon, amorphous silicon, an organic semiconductor, an oxide semiconductor, or the like.

The electronic apparatus may further include a sealing portion for sealing the light-emitting device. The sealing portion may be between the color filter and/or the color conversion layer and the light-emitting device. The sealing portion allows light from the light-emitting device to be extracted to the outside, and concurrently (e.g., simultaneously) prevents or reduces penetration of ambient air and/or moisture into the light-emitting device. The sealing portion may be a sealing substrate including a transparent glass substrate and/or a plastic substrate. The sealing portion may be a thin-film encapsulation layer including at least one layer of an organic layer and/or an inorganic layer. When the sealing portion is a thin film encapsulation layer, the electronic apparatus may be flexible.

Various suitable functional layers may be additionally on the sealing portion, in addition to the color filter and/or the color conversion layer, according to the use of the electronic apparatus. Examples of the functional layers may include a touch screen layer, a polarizing layer, and the like. The touch screen layer may be a pressure-sensitive touch screen layer, a capacitive touch screen layer, and/or an infrared touch screen layer. The authentication apparatus may be, for example, a biometric authentication apparatus that authenticates an individual by using biometric information of a living body (for example, fingertips, pupils, etc.).

The authentication apparatus may further include, in addition to the light-emitting device as described above, a biometric information collector.

The electronic apparatus may be applied to various suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, and/or endoscope displays), fish finders, various suitable measuring instruments, meters (for example, meters for a vehicle, an aircraft, and/or a vessel), projectors, and/or the like.

### Electronic device

The light-emitting device may be included in various suitable electronic device.

For example, the electronic device including the light-emitting device may be a flat panel display, a curved display, a computer monitor, a medical monitor, a television, a billboard, a light for indoor and/or outdoor lighting and/or signaling, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual or augmented-reality display, a vehicle, a video wall including multiple displays tiled together, a theater or stadium screen, a phototherapy device, and/or a signboard.

The light-emitting device may have excellent effects in terms of luminescence efficiency long lifespan, and thus the electronic device including the light-emitting device may have characteristics, such as high luminance, high resolution, and low power consumption.

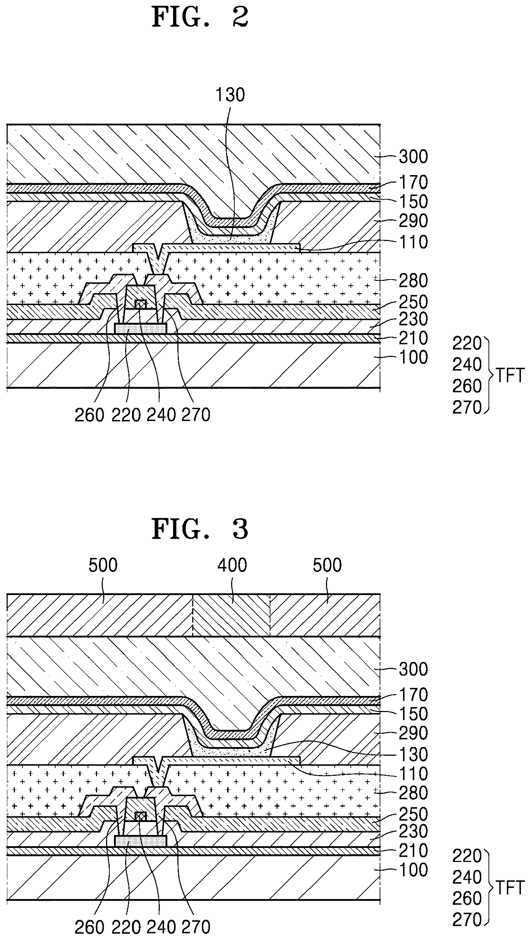

### Description of FIGS. 2 and 3

FIG. 2 is a cross-sectional view of an electronic apparatus according to one or more embodiments.

The electronic apparatus of FIG. 2 includes a substrate 100, a TFT, a light-emitting device, and an encapsulation portion 300 that seals the light-emitting device.

The substrate 100 may be a flexible substrate, a glass substrate, and/or a metal substrate. A buffer layer 210 may be on the substrate 100. The buffer layer 210 may prevent or reduce penetration of impurities through the substrate 100 and may provide a flat surface on the substrate 100.

A TFT may be on the buffer layer 210. The TFT may include an activation layer 220, a gate electrode 240, a source electrode 260, and a drain electrode 270.

The activation layer 220 may include an inorganic semiconductor such as silicon or polysilicon, an organic semiconductor, or an oxide semiconductor, and may include a source region, a drain region, and a channel region.

A gate insulating film 230 for insulating the activation layer 220 from the gate electrode 240 may be on the activation layer 220, and the gate electrode 240 may be on the gate insulating film 230.

An interlayer insulating film 250 may be on the gate electrode 240. The interlayer insulating film 250 may be between the gate electrode 240 and the source electrode 260 and between the gate electrode 240 and the drain electrode 270, to insulate from one another.

The source electrode 260 and the drain electrode 270 may be on the interlayer insulating film 250. The interlayer insulating film 250 and the gate insulating film 230 may expose the source region and the drain region of the activation layer 220, and the source electrode 260 and the drain electrode 270 may be in contact (e.g., physical contact) with the exposed portions of the source region and the drain region of the activation layer 220.

The TFT is electrically connected to a light-emitting device to drive the light-emitting device, and is covered and protected by a passivation layer 280. The passivation layer 280 may include an inorganic insulating film, an organic insulating film, or a combination thereof. A light-emitting device is provided on the passivation layer 280. The light-emitting device may include a first electrode 110, an interlayer 130, and a second electrode 150.

The first electrode 110 may be on the passivation layer 280. The passivation layer 280 may expose a portion of the drain electrode 270, not fully covering the drain electrode 270, and the first electrode 110 may be connected to the exposed portion of the drain electrode 270.

A pixel defining layer 290 including an insulating material may be on the first electrode 110. The pixel defining layer 290 may expose a certain region of the first electrode 110, and an interlayer 130 may be formed in the exposed region of the first electrode 110. The pixel defining layer 290 may be a polyimide and/or polyacrylic organic film. In one or more embodiments, at least some layers of the interlayer 130 may extend beyond the upper portion of the pixel defining layer 290 in the form of a common layer.

The second electrode 150 may be on the interlayer 130, and a capping layer 170 may be additionally formed on the second electrode 150. The capping layer 170 may cover the second electrode 150.

The encapsulation portion 300 may be on the capping layer 170. The encapsulation portion 300 may be on a light-emitting device to protect the light-emitting device from moisture and/or oxygen. The encapsulation portion 300 may include: an inorganic film including silicon nitride (SiNx), silicon oxide (SiOx), indium tin oxide, indium zinc oxide, or a combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or a combination thereof; or a combination of the inorganic films and the organic films.

FIG. 3 is a cross-sectional view of an electronic apparatus according to another embodiment.

The electronic apparatus of FIG. 3 is substantially the same as the light-emitting apparatus of FIG. 2, except that a light-shielding pattern 500 and a functional region 400 are additionally on the encapsulation portion 300. The functional region 400 may be i) a color filter area, ii) a color conversion area, or iii) a combination of the color filter area and the color conversion area. In one or more embodiments, the light-emitting device included in the electronic apparatus of FIG. 3 may be a tandem light-emitting device.

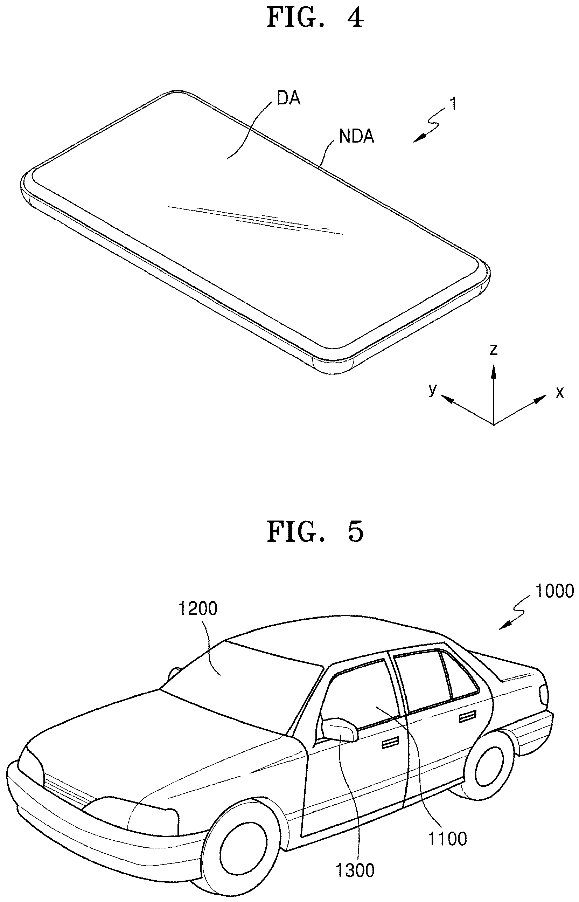

### Description of FIG. 4

FIG. 4 is a schematic perspective view of electronic device 1 including a light-emitting device according to one or more embodiments. The electronic device 1 may be, as a device apparatus, that displays a moving image and/or still image, a portable electronic device, such as a mobile phone, a smart phone, a tablet personal computer (PC), a mobile communication terminal, an electronic notebook, an electronic book, a portable multimedia player (PMP), a navigation, and/or a ultra mobile PC (UMPC) as well as various suitable products, such as a television, a laptop, a monitor, a billboard, and/or an Internet of things (IOT) device. The electronic device 1 may be such a product above or a part thereof. In addition, the electronic device 1 may be a wearable device, such as a smart watch, a watch phone, a glasses-type display, and/or a head mounted display (HMD), or a part of the wearable device. However, embodiments are not limited thereto. For example, the electronic device 1 may be a center information display (CID) on an instrument panel and a center fascia and/or dashboard of a vehicle, a room mirror display instead of a side mirror of a vehicle, an entertainment display for the rear seat of a car and/or a display placed on the back of the front seat, a head up display (HUD) installed in front of a vehicle or projected on a front window glass, and/or a computer generated hologram augmented reality head up display (CGH AR HUD). FIG. 4 illustrates a case in which the electronic device 1 is a smartphone for convenience of explanation.

The electronic device 1 may include a display area DA and a non-display area NDA outside the display area DA. The electronic device 1 may realize an image through an array of a plurality of pixels that are two-dimensionally in the display area DA.

The non-display area NDA is an area that does not display an image, and may entirely surround the display area DA. A driver for providing electrical signals or power to display devices on the display area DA may be on the non-display area NDA. A pad, which is an area to which an electronic element or a printing circuit board may be electrically connected, may be on the non-display area NDA,.

In the electronic device 1, a length in the x-axis direction and a length in the y-axis direction may be different from each other. For example, as shown in FIG. 4, the length in the x-axis direction may be shorter than the length in the y-axis direction. In one or more embodiments, the length in the x-axis direction may be the same as the length in the y-axis direction. In one or more embodiments, the length in the x-axis direction may be longer than the length in the y-axis direction.

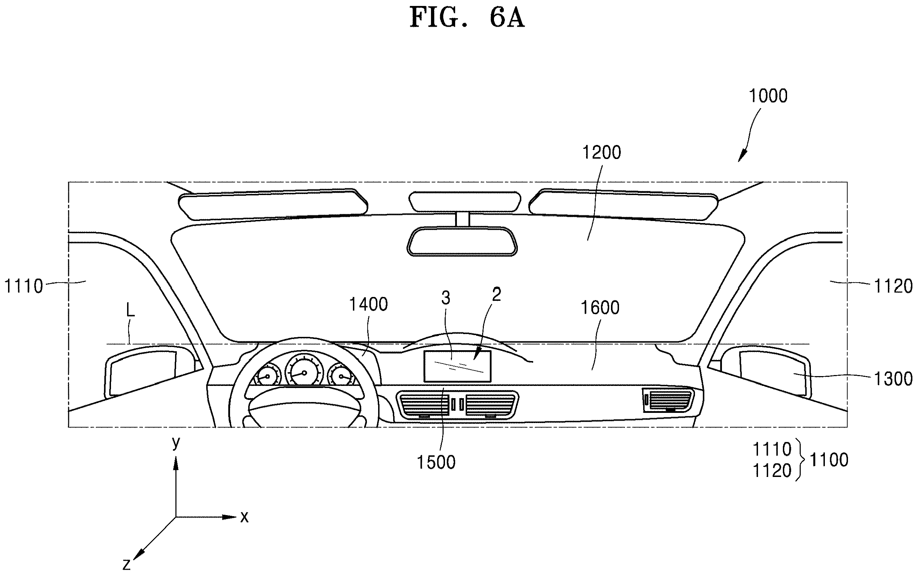

### Descriptions of FIGS. 5 and 6A to 6C

FIG. 5 is a diagram illustrating the exterior of a vehicle 1000 as an electronic device including a light-emitting device according to one or more embodiments. FIGS. 6A to 6C are each a schematic view illustrating the interior of the vehicle 1000 of FIG. 5.

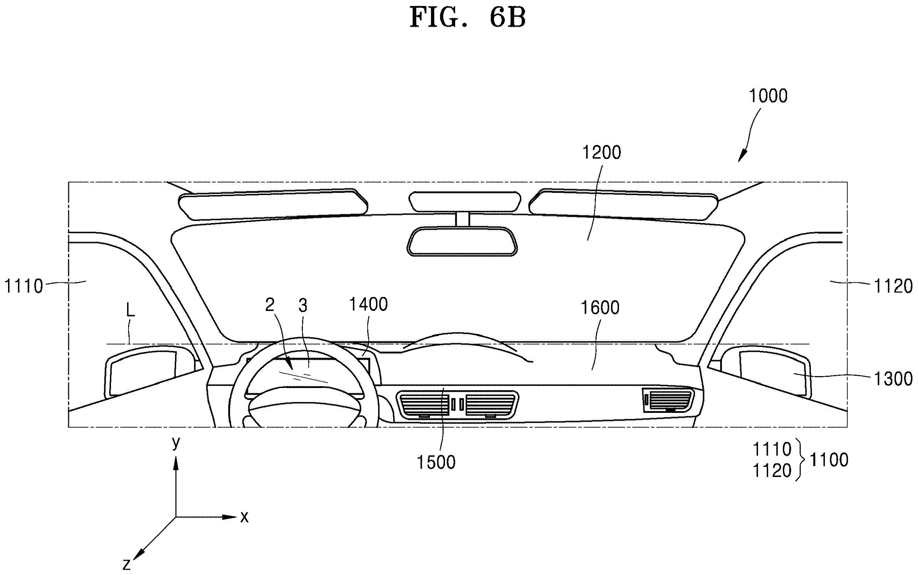

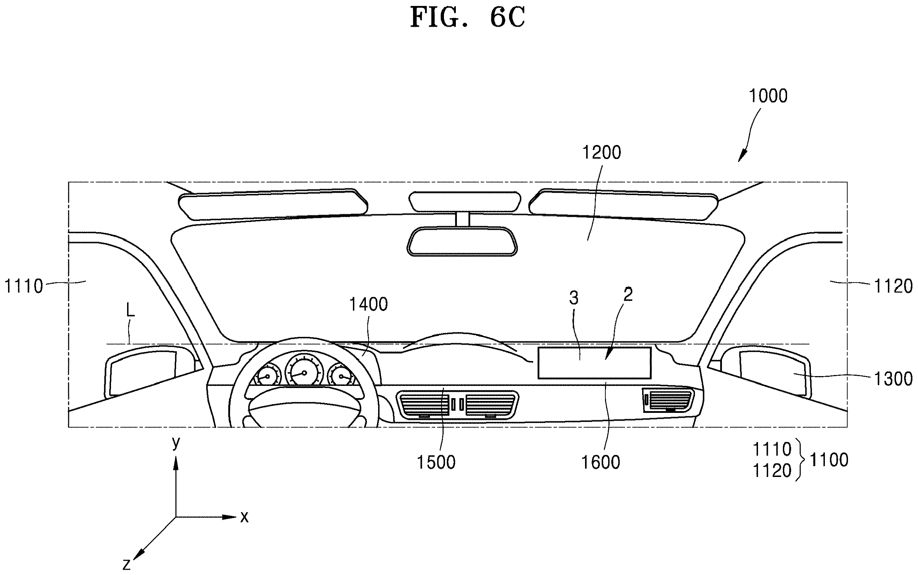

Referring to FIGS. 5, 6A, 6B, and 6C, the vehicle 1000 may refer to various suitable apparatuses for moving a subject object to be transported, such as a human, an object, and/or an animal, from a departure point to a destination. The vehicle 1000 may include a vehicle traveling on a road and/or track, a vessel moving over a sea and/or river, an airplane flying in the sky using the action of air, and/or the like.

The vehicle 1000 may travel on a road and/or a track. The vehicle 1000 may move in a set or predetermined direction according to the rotation of at least one wheel. For example, the vehicle 1000 may include a three-wheeled or four-wheeled vehicle, a construction machine, a two-wheeled vehicle, a prime mover device, a bicycle, and/or a train running on a track.

The vehicle 1000 may include a body having an interior and an exterior, and a chassis in which mechanical apparatuses necessary or suitable for driving are installed as other parts except for the body. The exterior of the vehicle body may include a front panel, a bonnet, a roof panel, a rear panel, a trunk, a filler provided at a boundary between doors, and/or the like. The chassis of the vehicle 1000 may include a power generating device, a power transmitting device, a driving device, a steering device, a braking device, a suspension device, a transmission device, a fuel device, front and rear wheels, left and right wheels, and the like.

The vehicle 1000 may include a side window glass 1100, a front window glass 1200, a side mirror 1300, a cluster 1400, a center fascia 1500, a passenger seat dashboard 1600, and a display device 2.

The side window glass 1100 and the front window glass 1200 may be partitioned by a filler between the side window glass 1100 and the front window glass 1200.

The side window glass 1100 may be installed on the side of the vehicle 1000. In one or more embodiments, the side window glass 1100 may be installed on a door of the vehicle 1000. A plurality of side window glasses 1100 may be provided and may face each other. In one or more embodiments, the side window glass 1100 may include a first side window glass 1110 and a second side window glass 1120. In one or more embodiments, the first side window glass 1110 may be adjacent to the cluster 1400. The second side window glass 1120 may be adjacent to the passenger seat dashboard 1600.

In one or more embodiments, the side window glasses 1100 may be spaced apart from each other in the x-direction or the -x-direction. For example, the first side window glass 1110 and the second side window glass 1120 may be spaced apart from each other in the x direction or the -x direction. In other words, an imaginary straight line L connecting the side window glasses 1100 may extend in the x-direction or the -x-direction. For example, an imaginary straight line L connecting the first side window glass 1110 and the second side window glass 1120 to each other may extend in the x direction or the -x direction.

The front window glass 1200 may be installed in the front of the vehicle 1000. The front window glass 1200 may be between the side window glasses 1100 facing each other.

The side mirror 1300 may provide a rear view of the vehicle 1000. The side mirror 1300 may be installed on the exterior of the vehicle body. In one embodiment, a plurality of side mirrors 1300 may be provided. Any one of the plurality of side mirrors 1300 may be outside the first side window glass 1110. The other one of the plurality of side mirrors 1300 may be outside the second side window glass 1120.

The cluster 1400 may be in front of the steering wheel. The cluster 1400 may include a tachometer, a speedometer, a coolant thermometer, a fuel gauge turn indicator, a high beam indicator, a warning lamp, a seat belt warning lamp, an odometer, a hodometer, an automatic shift selector indicator lamp, a door open warning lamp, an engine oil warning lamp, and/or a low fuel warning light.

The center fascia 1500 may include a control panel including a plurality of buttons for adjusting an audio device, an air conditioning device, and a heater of a seat are. The center fascia 1500 may be on one side of the cluster 1400.

A passenger seat dashboard 1600 may be spaced apart from the cluster 1400 with the center fascia 1500 therebetween. In one or more embodiments, the cluster 1400 may correspond to a driver seat, and the passenger seat dashboard 1600 may correspond to a passenger seat. In one or more embodiments, the cluster 1400 may be adjacent to the first side window glass 1110, and the passenger seat dashboard 1600 may be adjacent to the second side window glass 1120.

In one or more embodiments, the display device 2 may include a display panel 3, and the display panel 3 may display an image. The display device 2 may be inside the vehicle 1000. In one or more embodiments, the display device 2 may be between the side window glasses 1100 facing each other. The display device 2 may be on at least one selected from the cluster 1400, the center fascia 1500, and the passenger seat dashboard 1600.

The display device 2 may include an organic light-emitting display device, an inorganic electroluminescent (EL) display device, a quantum dot display device, and/or the like. Hereinafter, as the display device 2 according to one or more embodiments, an organic light-emitting display device display including the light-emitting device according to the present disclosure will be described as an example, but various suitable types (or kinds) of display devices as described above may be used in embodiments.

Referring to FIG. 6A, the display device 2 may be on the center fascia 1500. In one or more embodiments, the display device 2 may display navigation information. In one or more embodiments, the display device 2 may display audio, video, and/or information regarding vehicle settings.

Referring to FIG. 6B, the display device 2 may be on the cluster 1400. When the display device 2 is on the cluster 1400, the cluster 1400 may display driving information and the like through the display device 2. For example, the cluster 1400 may be implemented digitally. The digital cluster 1400 may display vehicle information and driving information as images. For example, a needle and a gauge of a tachometer and various suitable warning light icons may be displayed by a digital signal.

Referring to FIG. 6C, the display device 2 may be on the dashboard 1600 of the passenger seat. The display device 2 may be embedded in the passenger seat dashboard 1600 or on the passenger seat dashboard 1600. In one or more embodiments, the display device 2 on the dashboard 1600 for the passenger seat may display an image related to information displayed on the cluster 1400 and/or information displayed on the center fascia 1500. In one or more embodiments, the display device 2 on the passenger seat dashboard 1600 may display information different from information displayed on the cluster 1400 and/or information displayed on the center fascia 1500.

### Manufacturing method

Respective layers included in the hole transport region 120, the emission layer 130, and respective layers included in the electron transport region 140 may be formed in a certain region by using one or more suitable methods selected from vacuum deposition, spin coating, casting, Langmuir-Blodgett (LB) deposition, ink-jet printing, laser-printing, laser-induced thermal imaging (LITI), etc.

When respective layers included in the hole transport region 120, the emission layer 130, and respective layers constituting the electron transport region 140 are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### Definition of terms

The term "C₃-C₆₀ carbocyclic group" as used herein refers to a cyclic group having 3 to 60 carbon atoms in which a ring-forming atom consists of carbon atoms only. The term "C₁-C₆₀ heterocyclic group" as used herein refers to a cyclic group having 1 to 60 carbon atoms in which a ring-forming atom further includes heteroatoms in addition to carbon atoms. The C₃-C₆₀ carbocyclic group and the C₁-C₆₀ heterocyclic group may each be a monocyclic group consisting of one ring or a polycyclic group in which two or more rings are condensed together with each other. For example, the C₁-C₆₀ heterocyclic group has 3 to 61 ring-forming atoms.

The term "cyclic group" as used herein may include the C₃-C₆₀ carbocyclic group, and the C₁-C₆₀ heterocyclic group.

The term "π electron-rich C₃-C₆₀ cyclic group" as used herein refers to a cyclic group having 3 to 60 carbon atoms that do not include *-N=*' as a ring-forming moiety.

The term "π electron-deficient nitrogen-containing C₁-C₆₀ cyclic group" as used herein refers to a heterocyclic group having 1 to 60 carbon atoms including *-N=*' as a ring-forming moiety.

For example,
the C₃-C₆₀ carbocyclic group may be i) a T1 group or ii) a condensed cyclic group in which two or more T1 groups are condensed together with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group).

The C₁-C₆₀ heterocyclic group may be i) a T2 group, ii) a condensed cyclic group in which at least two T2 groups are condensed together with each other, or iii) a condensed cyclic group in which at least one T2 group and at least one T1 group are condensed together with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.).

The π electron-rich C₃-C₆₀ cyclic group may be i) a T1 group, ii) a condensed cyclic group in which at least two T1 groups are condensed together with each other, iii) a T3 group, iv) a condensed cyclic group in which at least two T3 groups are condensed together with each other, or v) a condensed cyclic group in which at least one T3 group and at least one T1 group are condensed together with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.).

The π electron-deficient nitrogen-containing C₁-C₆₀ cyclic group may be i) a T4 group, ii) a condensed cyclic group in which at least two T4 groups are condensed together with each other, iii) a condensed cyclic group in which at least one T4 group and at least one T1 group are condensed together with each other, iv) a condensed cyclic group in which at least one T4 group and at least one T3 group are condensed together with each other, or v) a condensed cyclic group in which at least one T4 group, at least one T1 group, and at least one T3 group are condensed together with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.).

The T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group.

The T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group.

The T3 group may be a furan group, a thiophene group, a 1H-pyrrole group, a silole group, or a borole group.

The T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the C₃-C₆₀ carbocyclic group, the C₁-C₆₀ heterocyclic group, the π electron-rich C₃-C₆₀ cyclic group, or the π electron-deficient nitrogen-containing C₁-C₆₀ cyclic group" as used herein refer to i) a group condensed to any cyclic group, ii) a monovalent group, or a iii) polyvalent group (for example, a divalent group, a trivalent group, a tetravalent group, etc.) according to the structure of a formula for which the corresponding term is used.

For example, the "benzene group" may be a benzo group, a phenyl group, a phenylene group, or the like, which may be easily understood by one of ordinary skill in the art according to the structure of a formula including the "benzene group."

For example, a monovalent C₃-C₆₀ carbocyclic group and a monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group.

Examples of a divalent C₃-C₆₀ carbocyclic group and a divalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a divalent non-aromatic condensed heteropolycyclic group.

The term "C₁-C₆₀ alkyl group" as used herein refers to a linear or branched aliphatic hydrocarbon monovalent group that has one to sixty carbon atoms, and examples thereof include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group.

The term "C₁-C₆₀ alkylene group" as used herein refers to a divalent group having substantially the same structure as the C₁-C₆₀ alkyl group.

The term "C₂-C₆₀ alkenyl group" as used herein refers to a monovalent hydrocarbon group having at least one carbon-carbon double bond at a main chain (e.g., in the middle) or at a terminal end (e.g., the terminus) of the C₂-C₆₀ alkyl group, and examples thereof include an ethenyl group, a propenyl group, and a butenyl group.

The term "C₂-C₆₀ alkenylene group" as used herein refers to a divalent group having substantially the same structure as the C₂-C₆₀ alkenyl group.

The term "C₂-C₆₀ alkynyl group" as used herein refers to a monovalent hydrocarbon group having at least one carbon-carbon triple bond at a main chain (e.g., in the middle) or at a terminal end (e.g., the terminus) of the C₂-C₆₀ alkyl group, and examples thereof include an ethynyl group, a propynyl group, etc.

The term "C₂-C₆₀ alkynylene group" as used herein refers to a divalent group having substantially the same structure as the C₂-C₆₀ alkynyl group.

The term "C₁-C₆₀ alkoxy group" as used herein refers to a monovalent group represented by -OA₁₀₁ (wherein A₁₀₁ is the C₁-C₆₀ alkyl group), and examples thereof include a methoxy group, an ethoxy group, and an isopropyloxy group.

The term "C₃-C₁₀ cycloalkyl group" as used herein refers to a monovalent saturated hydrocarbon cyclic group having 3 to 10 carbon atoms, and examples thereof include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group.

The term "C₃-C₁₀ cycloalkylene group" as used herein refers to a divalent group having substantially the same structure as the C₃-C₁₀ cycloalkyl group.

The term "C₁-C₁₀ heterocycloalkyl group" as used herein refers to a monovalent cyclic group of 1 to 10 carbon atoms, further including, in addition to carbon atoms, at least one heteroatom, as ring-forming atoms, and examples include a 1,2,3,4-oxatriazolidinyl group, a tetrahydrofuranyl group, and a tetrahydrothiophenyl group.

The term C₁-C₁₀ heterocycloalkylene group" as used herein refers to a divalent group having substantially the same structure as the C₁-C₁₀ heterocycloalkyl group.

The term C₃-C₁₀ cycloalkenyl group used herein refers to a monovalent cyclic group that has three to ten carbon atoms and at least one carbon-carbon double bond in the ring thereof and no aromaticity (e.g., is not aromatic), and examples thereof include a cyclopentenyl group, a cyclohexenyl group, and a cycloheptenyl group.

The term "C₃-C₁₀ cycloalkenylene group" as used herein refers to a divalent group having substantially the same structure as the C₃-C₁₀ cycloalkenyl group.

The term C₁-C₁₀ heterocycloalkenyl group" as used herein refers to a monovalent cyclic group of 1 to 10 carbon atoms, further including, in addition to carbon atoms, at least one heteroatom, as ring-forming atoms, and having at least one carbon-carbon double bond in the cyclic structure thereof. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group.

The term "C₁-C₁₀ heterocycloalkenylene group" as used herein refers to a divalent group having substantially the same structure as the C₁-C₁₀ heterocycloalkenyl group.

The term "C₆-C₆₀ aryl group" as used herein refers to a monovalent group having a carbocyclic aromatic system having 6 to 60 carbon atoms.

The term "C₆-C₆₀ arylene group" as used herein refers to a divalent group having a carbocyclic aromatic system having 6 to 60 carbon atoms.

Examples of the C₆-C₆₀ aryl group include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group.

When the C₆-C₆₀ aryl group and the C₆-C₆₀ arylene group each include two or more rings, the rings may be condensed together with each other.

The term "C₁-C₆₀ heteroaryl group" as used herein refers to a monovalent group having a heterocyclic aromatic system having 1 to 60 carbon atoms and further including at least one heteroatom as a ring-forming atom in addition to carbon atoms.

The term "C₁-C₆₀ heteroarylene group" as used herein refers to a divalent group having a heterocyclic aromatic system having 1 to 60 carbon atoms and further including at least one heteroatom as a ring-forming atom in addition to carbon atoms.

Examples of the C₁-C₆₀ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group.

When the C₁-C₆₀ heteroaryl group and the C₁-C₆₀ heteroarylene group each include two or more rings, the rings may be condensed together with each other.

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure (e.g., is not aromatic when considered as a whole). Examples of the monovalent non-aromatic condensed polycyclic group include an indenyl group, a fluorenyl group, a spiro-bifluorenyl group, a benzofluorenyl group, an indenophenanthrenyl group, and an indeno anthracenyl group.

The term "divalent non-aromatic condensed polycyclic group" as used herein refers to a divalent group having substantially the same structure as the monovalent non-aromatic condensed polycyclic group described above.

The term "monovalent non-aromatic condensed heteropolycyclic group" as used herein refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure (e.g., is not aromatic when considered as a whole). Examples of the monovalent non-aromatic condensed heteropolycyclic group include a pyrrolyl group, a thiophenyl group, a furanyl group, an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group.

The term "divalent non-aromatic condensed heteropolycyclic group" as used herein refers to a divalent group having substantially the same structure as the monovalent non-aromatic condensed heteropolycyclic group described above.

The term "C₆-C₆₀ aryloxy group" as used herein refers to -OA₁₀₂ (here, A₁₀₂ is the C₆-C₆₀ aryl group).

The term "C₆-C₆₀ arylthio group" as used herein refers to -SA₁₀₃ (here, A₁₀₃ is the C₆-C₆₀ aryl group).

The term "C₇-C₆₀ arylalkyl group" as used herein refers to -A₁₀₄A₁₀₅ (here, A₁₀₄ is a C₁-C₅₄ alkylene group and A₁₀₅ is a C₆-C₅₉ aryl group).

The term "C₂-C₆₀ heteroarylalkyl group" as used herein refers to -A₁₀₆A₁₀₇ (here, A₁₀₆ is a C₁-C₅₉ alkylene group and A₁₀₇ is a C₁-C₅₉ heteroaryl group).

The term "R₁₀ₐ" as used herein refers to:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or a combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q₁₃, Q₂₁ to Q₂₃ and Q₃₁ to Q₃₃ used herein may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or a combination thereof; a C₇-C₆₀ arylalkyl group; or a C₂-C₆₀ heteroarylalkyl group.

The term "heteroatom" as used herein refers to any atom other than a carbon atom. Examples of the heteroatom are O, S, N, P, Si, B, Ge, Se, and a combination thereof.

The term "third-row transition metal" used herein includes hafnium (Hf), tantalum (Ta), tungsten (W), rhenium (Re), osmium (Os), iridium (Ir), platinum (Pt), gold (Au), and the like.

"Ph" as used herein refers to a phenyl group, "Me" as used herein refers to a methyl group, "Et" as used herein refers to an ethyl group, "tert-Bu" or "Bu^{t}" as used herein refers to a tert-butyl group, and "Ome" as used herein refers to a methoxy group.

The term "biphenyl group" as used herein refers to "a phenyl group substituted with a phenyl group." In other words, the "biphenyl group" is a substituted phenyl group having a C₆-C₆₀ aryl group as a substituent.

The term "terphenyl group" as used herein refers to "a phenyl group substituted with a biphenyl group". In other words, the "terphenyl group" is a substituted phenyl group having, as a substituent, a C₆-C₆₀ aryl group substituted with a C₆-C₆₀ aryl group.

* and *' as used herein, unless defined otherwise, each refer to a binding site to a neighboring atom in a corresponding formula or moiety.

In the present specification, the x-axis, y-axis, and z-axis are not limited to three axes in an orthogonal coordinate system, and may be interpreted in a broad sense including these axes. For example, the x-axis, y-axis, and z-axis may refer to those orthogonal to each other, or may refer to those in different directions that are not orthogonal to each other.

Hereinafter, a light-emitting device according to embodiments will be described in more detail with reference to Examples.

### Examples

### Example 1

As an anode, a 15 Ω/cm² (1,200 Å) ITO glass substrate (product of Corning Inc.) was cut to a size of 50 mm x 50 mm x 0.7 mm, sonicated using isopropyl alcohol and pure water each for 5 minutes, and then washed by irradiation of ultraviolet rays and exposure of ozone thereto for 30 minutes. Then, the glass substrate was mounted on a vacuum deposition apparatus.

2-TNATA was vacuum-deposited on the substrate to form a hole injection layer having a thickness of 100 Å. 4,4'-bis[N-(1-naphthyl)-N-phenylamino]biphenyl (hereinafter, referred to as NPB) as a compound was vacuum-deposited on the hole injection layer to form a hole transport layer having a thickness of 1,200 Å.

A red emission layer emitting red light, a green emission layer emitting green light, and a blue emission layer emitting blue light were formed on the hole transport layer.

Alq₃ was vacuum-deposited on the emission layer to form an electron transport layer having a thickness of 310 Å.

Yb, Mg, and Ag were co-deposited on the electron transport layer to form an electron injection layer having a thickness of 8 Å. In this case, the deposition speed ratio of Yb, Mg, and Ag was 2:1:1.

A cathode (a second electrode) was formed on the electron injection layer, thereby completing the manufacture of a light-emitting device.

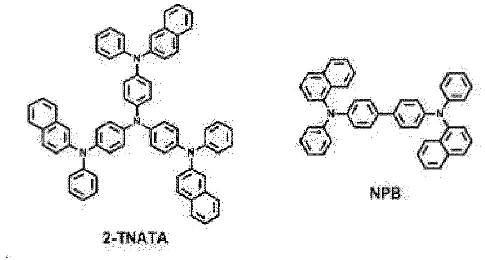

### Example 2

A light-emitting device was manufactured in substantially the same manner as in Example 1, except that the electron injection layer was formed to have a thickness of 10 Å.

### Example 3

A light-emitting device was manufactured in substantially the same manner as in Example 1, except that the electron injection layer was formed to have a thickness of 13 Å.

### Comparative Example 1

A light-emitting device was manufactured in substantially the same manner as in Example 1, except that, when forming an electron injection layer, only Yb was deposited instead of co-depositing Yb, Mg, and Ag.

### Comparative Example 2

A light-emitting device was manufactured in substantially the same manner as in Example 1, except that, when forming the electron injection layer, Yb and Mg were co-deposited in a deposition speed ratio of 1:1 instead of co-depositing Yb, Mg, and Ag in a deposition speed ratio of 2:1:1.

### Comparative Example 3

A light-emitting device was manufactured in substantially the same manner as in Example 1, except that, when forming the electron injection layer, Yb and Mg were co-deposited in a deposition speed ratio of 2.5:1 instead of co-depositing Yb, Mg, and Ag in a deposition speed ratio of 2:1:1.

### Comparative Example 4

A light-emitting device was manufactured in substantially the same manner as in Example 3, except that, when forming an electron injection layer, only Yb was deposited instead of co-depositing Yb, Mg, and Ag.

### Comparative Example 5

A light-emitting device was manufactured in substantially the same manner as in Example 3, except that, when forming the electron injection layer, Yb and Mg were co-deposited in a deposition speed ratio of 1:1 instead of co-depositing Yb, Mg, and Ag in a deposition speed ratio of 2:1:1.

### Comparative Example 6

A light-emitting device was manufactured in substantially the same manner as in Example 3, except that, when forming the electron injection layer, Yb and Mg were co-deposited in a deposition speed ratio of 2.5:1 instead of co-depositing Yb, Mg, and Ag in a deposition speed ratio of 2:1:1.

### Evaluation Example 1 Analysis of luminescence efficiency

The electron injection layer used in each of the light-emitting devices of Example 1 and Comparative Examples 1 to 3 is shown in Table 2.

The luminescence efficiency was measured using a spectrometer.

**Table 2**

| | Material for electron injection layer (deposition speed ratio) | Thickness of electron injection layer (Å) |
|---|---|---|
| Example 1 | Yb:Mg:Ag (2 : 1 : 1) | 8 |
| Comparative Example 1 | Yb | 8 |
| Comparative Example 2 | Yb:Mg (1 : 1) | 8 |
| Comparative Example 3 | Yb:Mg (2.5 : 1) | 8 |

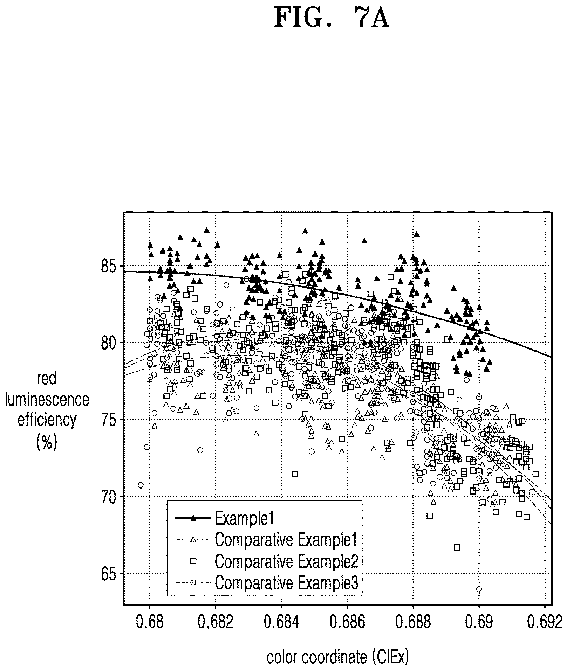

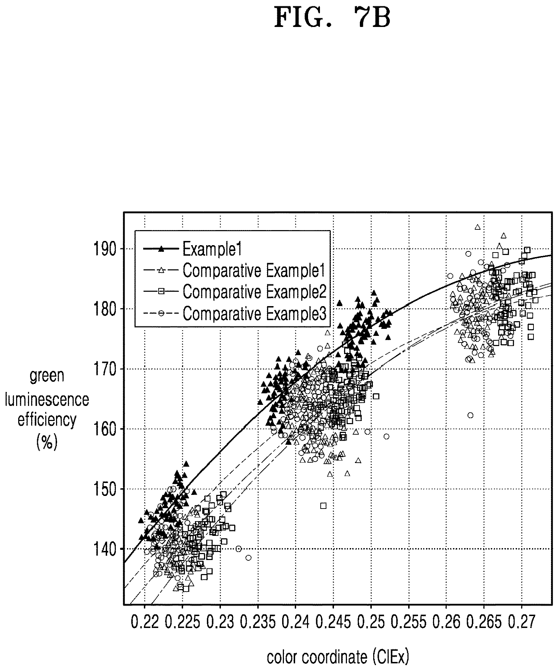

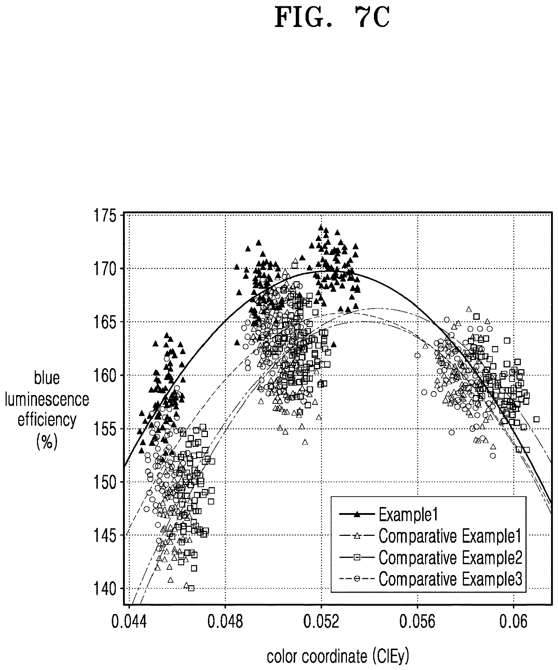

The luminescence efficiencies according to color coordinates (CIEx or CIEy) of the light-emitting devices of Example 1 and Comparative Examples 1 to 3 are shown in FIGS. 7A, 7B, and 7C. In particular, red luminescence efficiency is shown in FIG. 7A, green luminescence efficiency is shown in FIG. 7B, and blue luminescence efficiency is shown in FIG. 7C.

Referring to FIGS. 7A, 7B, and 7C, the luminescence efficiency of the light-emitting device of Example 1 was found to be excellent in all red, green, and blue regions, as compared with the luminescence efficiency of the light-emitting devices of Comparative Examples 1 to 3. The luminescence efficiency of the light-emitting device may be improved because the resonance in all red, green, and blue wavelength ranges has increased by forming the cathode to be a substantially flat and smooth thin film.

### Evaluation Example 2 Analysis of sheet resistance

In the light-emitting devices of Examples 1 to 3 and Comparative Examples 4 to 6, the sheet resistance of the second electrode on the electron injection layer was measured and results thereof are shown in Table 3.

The sheet resistance was measured using a 4-point sheet resistance measurer.

**Table 3**

| | Material for electron injection layer (deposition speed ratio) | Thickness of electron injection layer (Å) | Sheet resistance of second electrode (Ω/□) |
|---|---|---|---|
| Example 1 | Yb:Mg:Ag (2 : 1 : 1) | 8 | 12.6 |
| Example 2 | Yb:Mg:Ag (2 : 1 : 1) | 10 | 13.0 |
| Example 3 | Yb:Mg:Ag (2 : 1 : 1) | 13 | 13.7 |
| Comparative Example 4 | Yb | 13 | 15.7 |
| Comparative Example 5 | Yb:Mg (1 : 1) | 13 | 14.4 |
| Comparative Example 6 | Yb:Mg (2.5 : 1) | 13 | 15.6 |

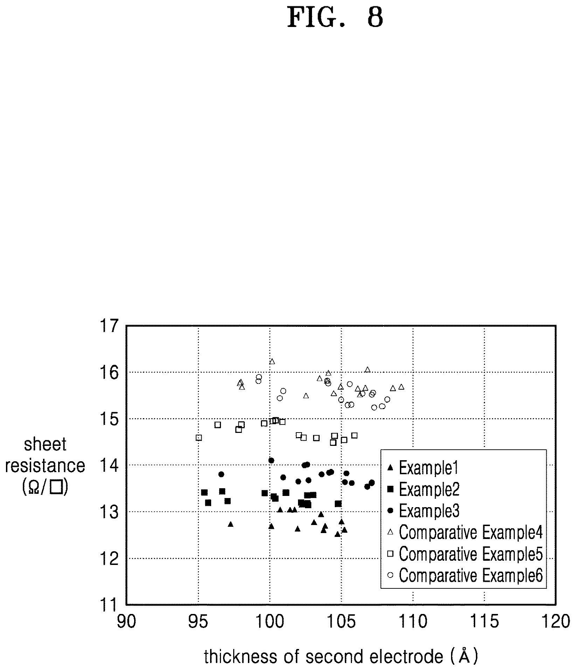

The sheet resistance of the cathode (the second electrode) according to the thickness of the cathode (the second electrode) in the light-emitting devices of Examples 1 to 3 and Comparative Examples 4 to 6 were measured, and results thereof are shown in FIG. 8.

Referring to Table 3 and FIG. 8, the sheet resistance of the cathode (the second electrode) of each of the light-emitting devices of Examples 1 to 3 were found to be less than the sheet resistance of the cathode (the second electrode) of each of the light-emitting devices of Comparative Examples 4 to 6. As the sheet resistance of the cathode (the second electrode) included in the light-emitting device is decreased, the driving voltage and power consumption of the light-emitting device may be improved.

As discussed, embodiments can provide a light-emitting device comprising: a first electrode; a second electrode facing the first electrode; an emission layer between the first electrode and the second electrode; and an electron transport region between the emission layer and the second electrode, wherein the electron transport region comprises an electron injection layer comprising a first material and a second material, wherein the first material and the second material each independently comprise an alkali metal, an alkaline earth metal, a transition metal, a post-transition metal, a lanthanide metal, or a combination thereof, wherein the second material does not comprise Mg, wherein the first material and the second material are different from each other, and wherein a surface energy of the second material is greater than a surface energy of the first material.

In one or more embodiments, the first material may include i) an alkali metal, an alkaline earth metal, and/or a lanthanide metal, ii) a halide of an alkali metal, a halide of an alkaline earth metal, and/or a halide of a lanthanide metal, or iii) a combination thereof. The first material may include Li, Na, K, Rb, Cs, Mg, Ca, Sr, Ba, La, Ce, Sm, Gd, Tb, Yb or a combination thereof. The first material may be LiF, and/or Yb.

In some embodiments, the second material may include a transition metal and/or a post-transition metal. The second material may be Ag, Au, Al, or a combination thereof.

In some embodiments, the surface energy of the second material may be about 0.8 J/m² or more. For example, the surface energy of the second material may be about 0.8 J/m² to about 3.5 J/m², or about 1.0 J/m² to about 3.5 J/m².

In some embodiments, a volume ratio of the first material to the second material in the electron injection layer is about 0.2:1 to about 4:1. In some embodiments, a volume of the first material included in the electron injection layer is greater than a volume of the second material included in the electron injection layer.

In some embodiments the electron injection layer may have a multi-layer. For example, the electron injection layer may have a multi-layer structure including a plurality of layers in which a first layer including the first material, a second layer including the second material, and/or a third layer including the third material are included. In some embodiments, the first material, the second material, and the third material may be included in a first layer of the multi-layer of the electron injection layer as a mixture, and a remaining layer or remaining layers of the multi-layer may or may not include the first material, the second material, and/or the third material. When the electron injection layer has a multi-layer structure including a plurality of layers, at least the layer closest to the second electrode includes the first material and/or the second material. In some embodiments, layer closest to the second electrode includes the second material. In some embodiments, the third material may include an alkaline earth metal. For example, the third material may be Mg and/or Ca.

In some embodiments, the volume ratio of the second material to the third material in the electron injection layer may be about 1.2:1 to about 1:1.2. In one or more embodiments, the volume ratio of the second material to the third material in the electron injection layer may be about 1:1.

In some embodiments, the thickness of the electron injection layer may be in a range of about 0.5 nm (5 Å) to about 2 nm (20 Å). For example, the thickness of the electron injection layer may be in a range of about 0.7 nm (7 Å) to about 1.8 nm (18 Å). For example, the thickness of the electron injection layer may be about 0.8nm (8 Å) to about 1.5 nm (15 Å).

Embodiments can provide an electronic apparatus comprising the light-emitting device of any one of the above discussed embodiments.

According to one or more embodiments, because an electron injection layer includes a second material having relatively greater a surface energy, a cathode may be substantially flat. As the cathode is formed to substantially flat, a resonance of a light-emitting device may increase and a sheet resistance of the cathode may be reduced. Accordingly, the luminescence efficiency, driving voltage, and power consumption of the light-emitting device may be improved.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims, and equivalents thereof.

## Claims

1. A light-emitting device comprising:
a first electrode;
a second electrode facing the first electrode;
an emission layer between the first electrode and the second electrode; and
an electron transport region between the emission layer and the second electrode,
wherein the electron transport region comprises an electron injection layer comprising a first material and a second material,
wherein the first material and the second material each independently comprise an alkali metal, an alkaline earth metal, a transition metal, a post-transition metal, a lanthanide metal, or a combination thereof,
wherein the second material does not comprise Mg,
wherein the first material and the second material are different from each other, and
wherein a surface energy of the second material is greater than a surface energy of the first material.

2. The light-emitting device of claim 1 or 2, wherein the electron injection layer is a single layer.

3. The light-emitting device of claim 1 or 2, wherein the first material is i) an alkali metal, an alkaline earth metal, and/or a lanthanide metal, ii) a halide of an alkali metal, a halide of an alkaline earth metal, and/or a halide of a lanthanide metal, or iii) a combination thereof.

4. The light-emitting device of any one of claims 1 to 3, wherein the first material is LiF or Yb.

5. The light-emitting device of any one of claims 1 to 4, wherein the second material comprises a transition metal or a post-transition metal.

6. The light-emitting device of any one of claims 1 to 5, wherein the second material is Ag, Au, Al, or a combination thereof.

7. The light-emitting device of any one of claims 1 to 6, wherein the surface energy of the second material is about 0.8 J/m² or more.

8. The light-emitting device of any one of claims 1 to 7, wherein a volume of the first material included in the electron injection layer is greater than a volume of the second material included in the electron injection layer.

9. The light-emitting device of any one of claims 1 to 7, wherein a volume ratio of the first material to the second material in the electron injection layer is about 0.2:1 to about 4:1.

10. The light-emitting device of any one of claims 1 to 9, wherein:
the electron injection layer further comprises a third material comprising an alkali metal, an alkaline earth metal, a transition metal, a post-transition metal, a lanthanide metal, or a combination thereof, and
the third material is different from the first material and the second material.

11. The light-emitting device of claim 10, wherein the third material comprises an alkaline earth metal.

12. The light-emitting device of claim 10 or 11, wherein the third material is Mg or Ca.

13. The light-emitting device of any one of claims 10 to 12, wherein a radius of an atom of a metal included in the third material is less than a radius of an atom of a metal included in the first material.

14. The light-emitting device of any one of claims 10 to 14, wherein a volume of the second material included in the electron injection layer is substantially equal to a volume of the third material included in the electron injection layer.

15. The light-emitting device of any one of claims 1 to 14, wherein a thickness of the electron injection layer is about 0.5 nm to about 2 nm.

16. The light-emitting device of any one of claims 1 to 15, wherein the electron injection layer is formed by co-depositing the first material and the second material.

17. The light-emitting device of any one of claims 1 to 16, wherein the electron injection layer is in direct contact with the second electrode.

18. The light-emitting device of any one of claims 1 to 17, further comprising:
a hole transport region between the first electrode and the emission layer, wherein:
the hole transport region comprises a hole injection layer, a hole transport layer, an emission auxiliary layer, an electron blocking layer, or a combination thereof.

19. An electronic apparatus comprising the light-emitting device of any one of claims 1 to 18.

20. The electronic apparatus of claim 19, further comprising:
a thin-film transistor electrically connected to the first electrode; and
a color filter, a color conversion layer, a touch screen layer, a polarizing layer, or a combination thereof.
